# FASCICULE DE BREVET EUROPEEN

(11) **EP 3 642 914 B1**
(45) Date de publication et mention de la délivrance du brevet: **31.03.2021**
(21) Numéro de dépôt: 18737679.3
(22) Date de dépôt: 18.06.2018
(51) Int. Cl.: H01S 5/02, H01S 5/026, H01S 5/028, H01S 5/10, H01S 5/14, H01S 5/22

(54) **COMPOSANT LASER SEMICONDUCTEUR HYBRIDE ET PROCÉDÉ DE FABRICATION D'UN TEL COMPOSANT**
HYBRIDES HALBLEITERLASERBAUELEMENT UND VERFAHREN ZUR HERSTELLUNG EINES SOLCHEN BAUELEMENTS
HYBRID SEMICONDUCTOR LASER COMPONENT AND METHOD FOR MANUFACTURING SUCH A COMPONENT

(30) Priorité: 19.06.2017 FR 1755575
(43) Date de publication de la demande: 29.04.2020
(73) Titulaire: Commissariat à l'Énergie Atomique et aux Énergies Alternatives, 75015 Paris (FR)
(72) Inventeur: MENEZO, Sylvie, 38500 Voiron (FR); GIRARD, Olivier, 38120 Saint Egreve (FR)
(74) Mandataire: Brevalex
(86) Numéro de dépôt international: PCT/FR2018/051446
(87) Numéro de publication internationale: WO 2018/234673

(56) Documents cités:
- EP-A1- 2 866 316
- US-A1- 2008 002 929
- ZHANG CHONG ET AL: "Thermal Management of Hybrid Silicon Ring Lasers for High Temperature Operation", IEEE JOURNAL OF SELECTED TOPICS IN QUANTUM ELECTRONICS, IEEE SERVICE CENTER, PISCATAWAY, NJ, US, vol. 21, no. 6, 1 novembre 2015 (2015-11-01), pages 1-7, XP011585819, ISSN: 1077-260X, DOI: 10.1109/JSTQE.2015.2428057 [extrait le 2015-06-26]
- MATHEWS IAN ET AL: "Towards AlN optical cladding layers for thermal management in hybrid lasers", VISUAL COMMUNICATIONS AND IMAGE PROCESSING; 20-1-2004 - 20-1-2004; SAN JOSE,, vol. 9520, 1 juin 2015 (2015-06-01), pages 95200J-95200J, XP060055626, DOI: 10.1117/12.2178924 ISBN: 978-1-62841-730-2

## Description

### DOMAINE TECHNIQUE

L'invention se rapporte au domaine de l'électronique et de l'optoélectronique et concerne plus particulièrement les composants lasers semiconducteurs hybrides.

Ainsi, l'invention a pour objet un composant laser semiconducteur hybride et un procédé de fabrication d'un tel composant.

### ÉTAT DE LA TECHNIQUE ANTÉRIEURE

Afin de permettre une intégration de composants laser sur des supports semiconducteurs ou des systèmes photoniques qui ne sont pas adaptés, tels que des supports silicium ou les systèmes photoniques à base de silicium, il est connu d'utiliser des composants laser semiconducteur hybrides.

Afin d'exemplifier ce type de composants laser semiconducteur hybrides, il est renvoyé aux travaux d'A. W. FANG et al. qui ont été publiés le 31 mars 2008 dans la revue scientifique Optics Express volume 16 numéro 7 pages 4413-4419 qui concernent un laser semiconducteur hybride basé sur un couplage optique adiabatique par transformation de modes entre un module d'émission et un guide d'onde, et aux travaux de B. BEN BAKIR et al. qui ont été publiés en 2011 dans la revue scientifique Optics Express volume 19 numéro 11 pages 4413-4419 qui concernent un laser semiconducteur hybride basé sur un couplage optique évanescent entre un module d'émission et un guide d'onde.

De tels composants comportent généralement :
- un module d'émission comprenant une zone active réalisée en matériaux semiconducteurs à gap direct, tels que des semiconducteurs III-V, et conformée pour émettre un rayonnement électromagnétique à une longueur d'onde donnée,
- une couche optique comprenant au moins un guide d'onde couplé optiquement à la zone active, le guide d'onde formant avec la zone active une cavité optique résonnante à la longueur d'onde donnée.

Cette couche optique est généralement fournie au moyen d'une couche semiconductrice sur isolant, telle qu'une couche de silicium sur isolant d'un substrat SOI (sigle anglais pour silicon on insulator, c'est-à-dire silicium sur isolant, généralement du SiO2). Avec un tel substrat, la couche isolante repose sur un support en Silicium. Cette couche isolante du substrat SOI occasionne une isolation thermique entre la couche optique et le support silicium, ce qui est peu propice à l'évacuation de la chaleur produite par le module d'émission vers le substrat Silicium. Or les performances du module d'émission se dégradent fortement avec la température, et cessent de fonctionner à des températures supérieures à 70°C.

Ainsi, si ce type de composant autorise l'intégration de composants lasers sur des supports ou des systèmes photoniques non adaptés tels que des supports silicium, il présente l'inconvénient d'avoir une dissipation thermique insuffisante.

Afin de résoudre ce problème, M. SYSTAK et ses coauteurs ont proposé, dans le cadre de leurs travaux présentés en 2011 à la conférence « Optical Fiber Communication Conférence and Exposition and the National Fiber Optic Engineers Conférence », de prévoir des ponts de silicium amorphe entre le support silicium et le guide d'onde silicium (afin de connecter directement au travers de la couche isolante). De tels ponts peuvent être intégrés dans des ouvertures ménagées dans la couche optique et la couche isolante sans interaction avec le guide d'onde.

Si M. SYSTAK et ses co-auteurs ont observé une amélioration vis-à-vis de la température de fonctionnement du module d'émission, cette amélioration reste insuffisante et le composant laser hybride présente encore des performances dégradées.

T. GREAZZO et ses co-auteurs ont quant' à eux proposé dans le cadre de leurs travaux publiés en 2013 dans la revue scientifique « Optics Express », Volume 21 numéro 23 pages 28048-28053, d'intégrer le module d'émission dans une ouverture de la couche optique et de la couche isolante de telle manière à ce que le module optique soit en contact thermique direct avec le support silicium. Dans une telle configuration, la chaleur produite par le module d'émission lors du fonctionnement du laser hybride est évacuée par le support.

Si cette configuration proposée par T. GREAZZO et ses co-auteurs permet d'améliorer la température de fonctionnement, elle présente néanmoins un inconvénient majeur. En effet, le module d'émission étant placé dans une ouverture de la couche optique et de la couche d'isolant, le couplage entre le guide d'onde, se trouvant dans la couche optique, et le module d'émission est forcément un couplage bout à bout. Pour cette raison, une telle configuration n'est pas compatible avec d'autres types de couplage entre le module d'émission et le guide d'onde, tels que les couplages par transformation de mode et les couplages évanescents.

Pour finir, on notera que les solutions proposées par M. SYSTAK et T. GREAZZO avec leurs coauteurs nécessitent que la couche optique soit elle-même supportée par un support semiconducteur. Or certain systèmes photoniques ne comportent pas de support semiconducteur et présentent une couche optique dont les composants et les interconnexions sont entièrement encapsulés dans un matériau isolant.

On notera que la société ST™ a également développée une solution dans le but de préserver les performances les composants laser hybride du même type que ceux décrient par d'A. W. FANG et ses coauteurs. Cette solution consiste à intégrer sur une face du composant, celle qui entoure, avec la couche optique, le module d'émission, un radiateur en regard du module d'émission. Selon cette solution, une interconnexion métallique entre le module d'émission et le radiateur permet de fournir un pont thermique entre eux.

Néanmoins, si une telle solution permet un abaissement de la température de fonctionnement du module, cet abaissement n'est néanmoins pas suffisant pour permettre un fonctionnement optimisé du composant. En effet, avec la solution proposée par ST™ la face du composant comprenant le radiateur présente également l'électronique de commande du composant ce qui limite le dimensionnement du radiateur et donc la capacité d'évacuation de chaleur de ce dernier.

Il n'existe donc pas de solution satisfaisante pour fournir un composant laser hybride présentant des performances préservées, ceci quel que soit le type de couplage optique entre le guide d'onde et le module d'émission, en particulier pour les couplages optiques par transformation de modes et les couplages optiques évanescents. Il n'existe pas non plus de solution satisfaisante pour fournir un composant laser hybride présentant des performances préservées dans le cas où la couche optique ne comporte pas de support semiconducteur.

### EXPOSÉ DE L'INVENTION

L'invention vise à résoudre ces inconvénients et a donc pour premier but de fournir un composant laser hybride présentant des performances préservées sans perturbation de la connexion du composant à une électronique de commande, et dans lequel le couplage optique entre le module d'émission et le guide d'onde puisse être un couplage optique par transformation de modes ou évanescent.

L'invention a également pour but de fournir un composant laser hybride présentant des performances préservées ceci même dans le cas où la couche optique n'est pas en contact avec un support semiconducteur.

L'invention concerne à cet effet un composant laser semiconducteur hybride comportant :
- au moins un premier module d'émission comprenant une zone active réalisée en matériaux semiconducteurs à gap direct, tels que des semiconducteurs III-V, et conformée pour émettre un rayonnement électromagnétique à une longueur d'onde donnée,
- une couche optique comprenant au moins un premier guide d'onde couplé optiquement à la zone active, le premier guide d'onde formant avec la zone active une cavité optique résonnante à la longueur d'onde donnée,
   le composant laser semiconducteur hybride comportant en outre :
   - une couche semiconductrice dite de dissipation thermique, ladite couche semiconductrice de dissipation thermique étant en contact thermique avec le premier module d'émission sur une surface du premier module d'émission qui est opposée à la couche optique, et
   - au moins une première interconnexion pour connecter l'au moins premier module d'émission, ladite première interconnexion traversant la couche optique.De cette manière, en fonctionnement du laser semiconducteur hybride, la chaleur émise par le module d'émission peut être évacuée par la surface du premier module d'émission opposée à la couche optique, ceci sans aucune contrainte sur les autres surfaces du module d'émission. Ainsi, les surfaces du premier module d'émission qui sont soit en regard, soit transversales, de la couche optique, ne présentent aucune contrainte vis-à-vis de leur configuration et sont accessibles pour fournir le couplage optique entre le premier module d'émission et la couche optique.

Un tel composant laser autorise donc un couplage optique entre le guide d'onde et le premier module d'émission par la surface du module d'émission en regard de la couche optique, ceci par un couplage évanescent ou par transformation de modes, tout en présentant des performances préservées, puisque la chaleur générée peut être évacuée par la couche semiconductrice de dissipation thermique.

De plus, cette dissipation thermique est fournie par une couche semiconductrice qui est distincte d'un éventuel support de la couche optique. Ce type de composant laser hybride est donc parfaitement compatible avec les systèmes photoniques ne comportant pas de support semiconducteur.

On notera également que l'utilisation d'au moins une interconnexion pour connecter le premier module d'émission qui traverse la couche optique permet un déport de l'électronique de commande à l'opposé de la couche de dissipation. Ainsi, il est possible d'optimiser thermiquement les performances de fonctionnement du composant sans que cela n'interfère sur la connexion du composant à une électronique de commande.

Par « couche semiconductrice de dissipation thermique en contact thermique avec le premier module d'émission sur une surface du premier module d'émission qui est opposée à la couche optique », il doit être entendu ci-dessus et dans le reste de ce document que la résistance thermique entre la surface du premier module d'émission et la couche semiconductrice est inférieure à 1.10⁻⁷ m².K.W⁻¹, préférentiellement inférieure à 5.10⁻⁸ m².K.W¹ et encore plus avantageusement inférieure à 3.10⁻⁸ m².K.W⁻¹,voire 2.10⁻⁸ m².K.W⁻¹. Ainsi, le contact thermique entre la couche semiconductrice de dissipation thermique et la surface du premier module qui est opposée à la couche optique peut être obtenu par un contact direct entre ces dernières ou par l'intermédiaire d'une couche d'interface présentant une résistance thermique réduite.

Conformément à cette définition, avec un tel contact thermique, si on prend un premier module laser présentant une surface de contact de 1 mm par 5 µm et une puissance de 0,1 W à dissiper, une résistance thermique de 1.10 ⁻⁷ m².K.W¹ correspond à une différence de température de 3,33°C entre la surface du module et la surface de la couche de semiconductrice de dissipation thermique. Cette différence de température passe respectivement à 1,66°C et 0,66°C pour une résistance thermique de 5.10⁻⁸ m².K.W- et de 1.10⁻⁷ m².K.W⁻¹

Le module d'émission peut comprendre :
- une première zone semiconductrice d'un premier type de conductivité,
- la zone active en contact avec la première zone semiconductrice,
- une troisième zone semiconductrice d'un deuxième type de conductivité et étant en contact avec la zone active,
le module d'émission étant polarisé au travers des première et troisième zones semiconductrices,
dans lequel la troisième zone semiconductrice est en contact avec la première interconnexion, le module d'émission étant en contact thermique avec la couche semiconductrice de dissipation thermique au moyen de la première zone semiconductrice.

La couche semiconductrice de dissipation thermique peut s'étendre de part et d'autre du module d'émission.

La couche semiconductrice de dissipation thermique peut être en contact électrique avec la troisième zone semiconductrice et en comporte un contact métallique afin de permettre une polarisation du module d'émission.

La troisième zone semiconductrice peut être en contact thermique avec la couche semiconductrice de dissipation thermique au travers d'au moins une couche métallique à partir de laquelle s'étend au moins une deuxième interconnexion traversant la couche optique, ladite couche métallique étant isolée électriquement de la couche semiconductrice de dissipation thermique.

Le composant laser semiconducteur hybride peut comprendre en outre une deuxième interconnexion pour connecter l'au moins un premier module d'émission, la deuxième interconnexion étant en contact électrique avec la couche semiconductrice de dissipation thermique.

De cette manière la couche semiconductrice de dissipation thermique peut former un contact commun pour l'ensemble des modules d'émission, telle qu'une masse et/ou un contact P des modules d'émission.

Le composant laser semiconducteur hybride peut comprendre en outre une deuxième interconnexion pour connecter l'au moins un premier module d'émission, ladite deuxième interconnexion traversant la couche optique, ladite deuxième interconnexion comprenant préférentiellement :
- une première portion d'interconnexion s'étendant en direction de couche de dissipation thermique,
- une portion de couche métallique s'étendant sensiblement parallèlement à la couche semiconductrice de dissipation thermique, ladite portion étant en contact électrique avec la première portion d'interconnexion,
- une deuxième portion d'interconnexion s'étendant dans une direction opposée à la couche de dissipation thermique et traversant la couche optique, ladite deuxième portion d'interconnexion étant en contact électrique avec la portion de couche métallique.

De cette manière, l'ensemble des contacts pour connecter le module d'émission peuvent être fourni sur une face du composant qui est opposée à la couche semiconductrice de dissipation thermique.

Le composant laser semiconducteur hybride peut comprendre en outre :
- au moins un composant actif, tel qu'un modulateur optique, ledit composant actif étant logé dans la couche optique,
- au moins une troisième interconnexion pour connecter le composant actif, ladite troisième interconnexion s'étendant entre le composant actif et une face du composant laser opposée à la couche semiconductrice de dissipation thermique.

Le composant peut comprendre en outre au moins une quatrième interconnexion dite traversante, ladite quatrième interconnexion s'étendant entre une face du composant laser semiconducteur hybride qui est opposée à la couche semiconductrice de dissipation thermique et une face de la couche semiconductrice de dissipation thermique qui est opposée à la couche optique,
et ladite quatrième interconnexion peut présenter sur chacune de ladite face du composant laser semiconducteur hybride et de ladite face de la couche semiconductrice un plot de contact respectif.

De cette manière il est possible de fournir, à partir de cette au moins une quatrième interconnexion, une connexion externe pour une électronique de commande assemblée sur la face du composant qui est opposée à la couche semiconductrice de dissipation thermique.

La couche semiconductrice de dissipation thermique peut être une couche de silicium.

Une telle couche de dissipation thermique permet de bénéficier de la qualité cristallographique et des possibilités de dopage importants permis par le silicium. Il ainsi possible de choisir les caractéristiques de la couche semiconductrice de dissipation thermique adaptées pour dissiper l'énergie thermique transmise par le premier module d'émission.
le composant laser semiconducteur hybride peut comporter en outre au moins une première couche métallique en contact avec la couche semiconductrice de dissipation thermique sur une face de la couche semiconductrice de dissipation thermique qui est opposée au premier module d'émission.

Une telle première couche métallique permet de dissiper une partie de l'énergie thermique emmagasinée par la couche semiconductrice de dissipation thermique améliorant ainsi, de fait, la capacité de dissipation thermique de ladite couche semiconductrice. On notera, de plus, qu'une telle couche de métallique peut également servir de contact de masse dans le cas où la couche semiconductrice de dissipation thermique est en contact électrique avec la surface du premier module d'émission.

Le composant laser semiconducteur hybride peut comprendre en outre au moins une deuxième couche métallique en contact électrique avec le premier module d'émission sur la face du premier module d'émission qui est opposé à la couche optique,
la deuxième couche métallique participant au contact thermique entre la couche semiconductrice de dissipation thermique et le premier module d'émission.

Une telle deuxième couche métallique permet de fournir un bon contact thermique entre la surface de l'au moins module d'émission et la couche semiconductrice de dissipation thermique. De plus, une telle deuxième couche métallique peut avantageusement permettre, lors du procédé de fabrication d'un tel composant, un collage moléculaire de la couche semiconductrice de dissipation thermique comprenant ladite deuxième couche métallique sur une troisième couche métallique préalablement formée en contact avec la surface du premier module d'émission.

La couche semiconductrice de dissipation thermique peut être en contact électrique avec la deuxième couche métallique.

De cette manière, la couche de dissipation thermique peut également formée un contact de masse pour le premier module d'émission.

Il peut être prévu entre la deuxième couche métallique et la couche semiconductrice de dissipation thermique au moins une couche d'isolation électrique conformée pour isolé électriquement la deuxième couche métallique de la couche semiconductrice de dissipation thermique, la couche d'isolation électrique participant au contact thermique entre la couche semiconductrice de dissipation thermique et le premier module d'émission.

La couche semiconductrice de dissipation thermique étant isolée électriquement du premier module, il est possible d'utiliser une interconnexion individuelle pour le premier module d'émission. Ainsi, dans le cas où le composant laser semiconducteur hybride comporte au moins un module d'émission autre que le premier module d'émission, le premier et l'autre module d'émission sont isolés l'un de l'autre et peuvent être alimenter indépendamment l'un de l'autre.

Le premier module d'émission peut être inclus dans une couche d'encapsulation réalisée dans un matériau isolant, tel que le nitrure de silicium ou le dioxyde de silicium.

Le composant laser semiconducteur hybride peut comprendre en outre au moins un deuxième module d'émission comprenant une zone active réalisée en matériaux semiconducteurs à gap direct, tels que des semiconducteurs III-V, et conformée pour émettre un rayonnement électromagnétique à une deuxième longueur d'onde donnée différente ou identique à la première longueur d'onde donnée,
la couche optique comprenant en outre au moins un deuxième guide d'onde couplé optiquement à la zone active du deuxième module d'émission, ledit premier guide d'onde formant avec la zone active une cavité optique résonnante à la deuxième longueur d'onde donnée,
la couche semiconductrice de dissipation thermique étant en contact thermique avec le deuxième module d'émission sur une surface du deuxième module d'émission qui est opposée à la couche optique.

Un tel composant bénéficie de la possibilité de l'invention selon laquelle l'invention est compatible avec les procédés de fabrication collective de la microélectronique et de l'optoélectronique.

L'invention concerne en outre un procédé de fabrication d'un laser semiconducteur hybride, comportant les étapes suivantes :
- fourniture d'une couche optique comportant au moins un premier guide d'onde,
- fourniture d'au moins un premier module d'émission comprenant une zone active réalisée en matériaux semiconducteurs à gap direct, tels que des semiconducteurs III-V, et conformée pour émettre un rayonnement électromagnétique à une première longueur d'onde donnée, la zone active (étant couplée optiquement avec le premier guide d'onde et formant avec le premier guide d'onde une cavité optique résonnante à la longueur d'onde donnée,
- fourniture d'une couche semiconductrice dite de de dissipation thermique, ladite couche semiconductrice de dissipation thermique étant en contact thermique avec le premier module d'émission sur une surface du premier module d'émission qui est opposée à la couche optique.

Il peut être prévu une étape de formation d'au moins une première interconnexion pour connecter l'au moins premier module d'émission, ladite première interconnexion s'étendant en traversant la couche optique.

Un tel procédé permet la formation d'un composant laser semiconducteur hybride selon l'invention et donc de bénéficier des avantages qui y sont liés.

L'étape de fourniture d'une couche semiconductrice de dissipation thermique peut comprendre les sous-étapes suivantes :
- formation d'au moins une deuxième couche métallique en contact thermique avec le premier module d'émission sur la surface du premier module d'émission qui est opposée à la couche optique,
- fourniture de la couche semiconductrice de dissipation thermique,
- formation en contact thermique avec la couche semiconductrice de dissipation thermique d'une troisième couche métallique,
- collage moléculaire métallique de la deuxième couche métallique avec la troisième couche métallique de manière à mettre en contact thermique la surface du premier module d'émission qui est opposée à la couche optique et la couche semiconductrice de dissipation thermique en contact thermique.

Un tel procédé permet de fournir un composant laser hybride dont le contact thermique entre la couche semiconductrice de dissipation thermique et la surface de l'au moins module d'émission est optimisé puisqu'il est obtenu au moyen deux couches de métalliques.

Lors de l'étape de fourniture d'une couche semiconductrice de dissipation thermique il peut être prévu entre la sous-étape de fourniture de la couche semiconductrice de dissipation thermique et la sous-étape de formation de la troisième couche métallique, la sous-étape suivante
- formation d'au moins une moins une couche d'isolation électrique en contact thermique avec la couche semiconductrice de dissipation thermique,
la couche d'isolation électrique étant conformée pour isoler électriquement la deuxième couche métallique de la couche semiconductrice de dissipation thermique, la couche d'isolation électrique participant au contact thermique entre la couche semiconductrice de dissipation thermique et le premier module d'émission.

Un tel procédé permet la formation d'un composant laser semiconducteur hybride comportant un contact thermique et électrique entre la couche semiconductrice de dissipation thermique fourni notamment par la couche d'isolation électrique selon l'invention et de bénéficier des avantages liés à un tel composant.

Lors de l'étape de fourniture de la couche optique, la couche optique peut comporter au moins un deuxième guide d'onde,
lors de l'étape de fourniture de l'au moins un premier module d'émission il peut être est également fourni un deuxième module d'émission, le deuxième module d'émission comprenant une zone active réalisée en matériaux semiconducteurs à gap direct, tels que des semiconducteurs III-V, et conformée pour émettre un rayonnement électromagnétique à une deuxième longueur d'onde donnée différente ou identique à la première longueur d'onde donnée,
lors de l'étape de fourniture de la couche semiconductrice de dissipation thermique, ladite couche semiconductrice de dissipation thermique étant également en contact thermique avec le deuxième module d'émission sur une surface du deuxième module d'émission qui est opposée à la couche optique.

Un tel procédé permet de bénéficier des possibilités de fabrication collective offertes par la microélectrique et l'optoélectronique et ainsi de fabriquer un composant comportant plusieurs modules d'émission et donc de lasers semiconducteurs hybrides.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

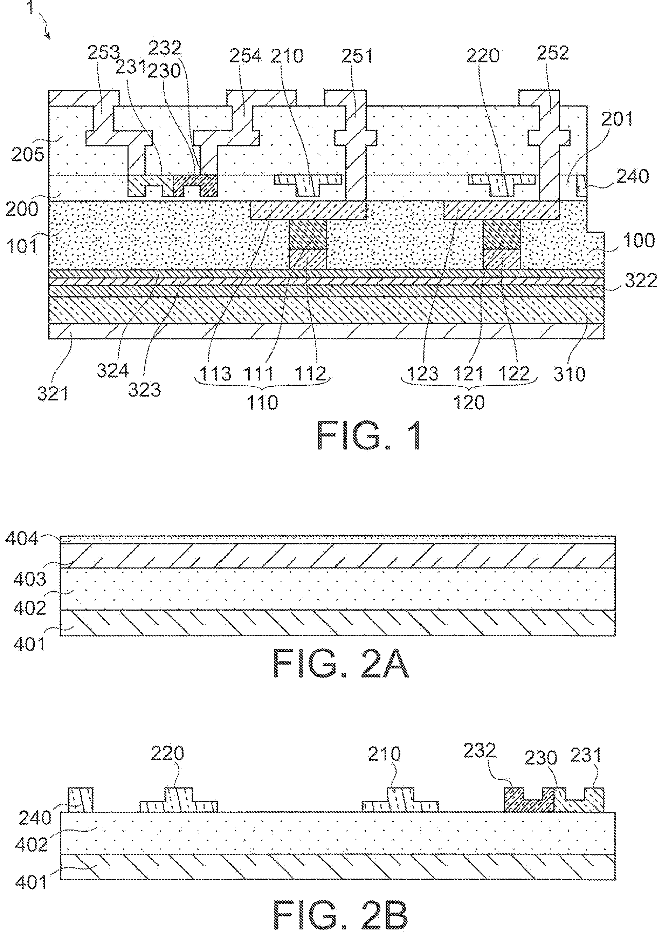

- la figure 1 est une coupe longitudinale schématique d'un composant laser semiconducteur hybride selon un premier mode de réalisation de l'invention,
- les figures 2A à 2M illustrent en vue en coupe longitudinale les principales étapes de fabrication d'un composant laser semiconducteur hybride tel qu'illustré sur la figure 1,

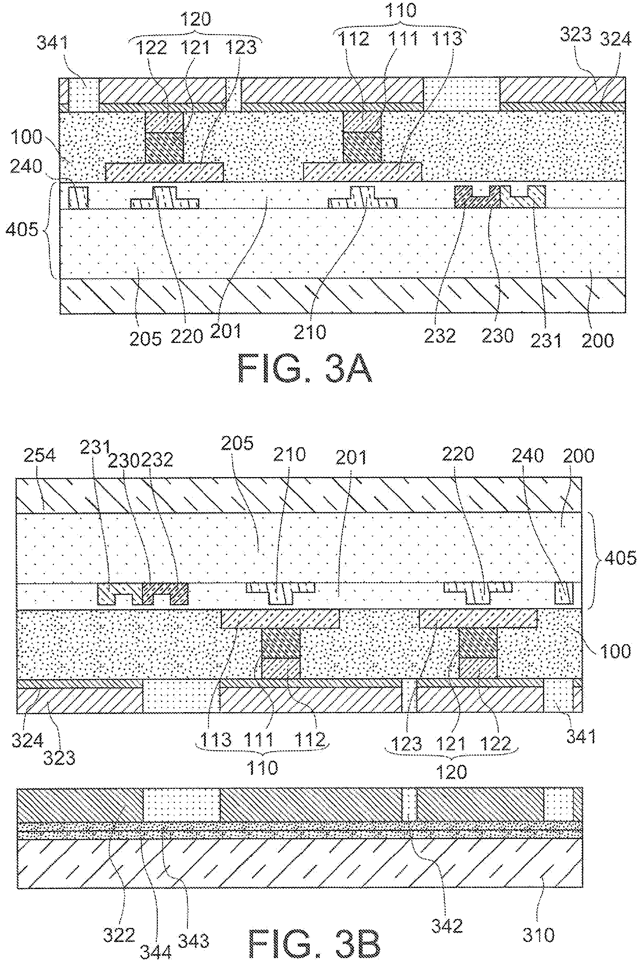

- les figures 3A à 3D illustrent schématiquement en coupe longitudinale les étapes de fabrication spécifiques d'un composant laser semiconducteur selon un deuxième mode de réalisation de l'invention dans lequel le contact thermique entre un premier module d'émission et une couche de dissipation thermique est fourni au moyen de couches de cuivre faisant également office de contact électrique pour ledit premier module d'émission,

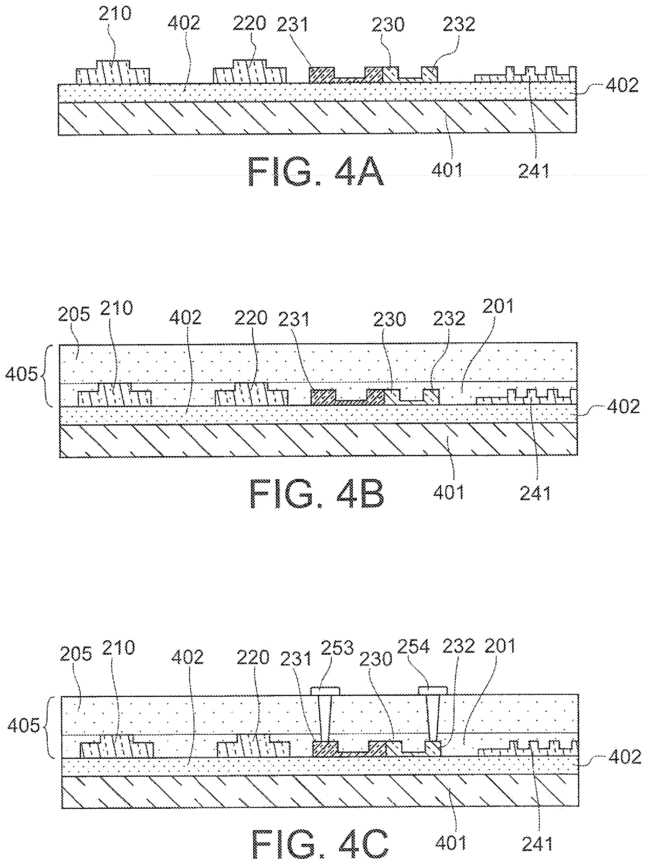

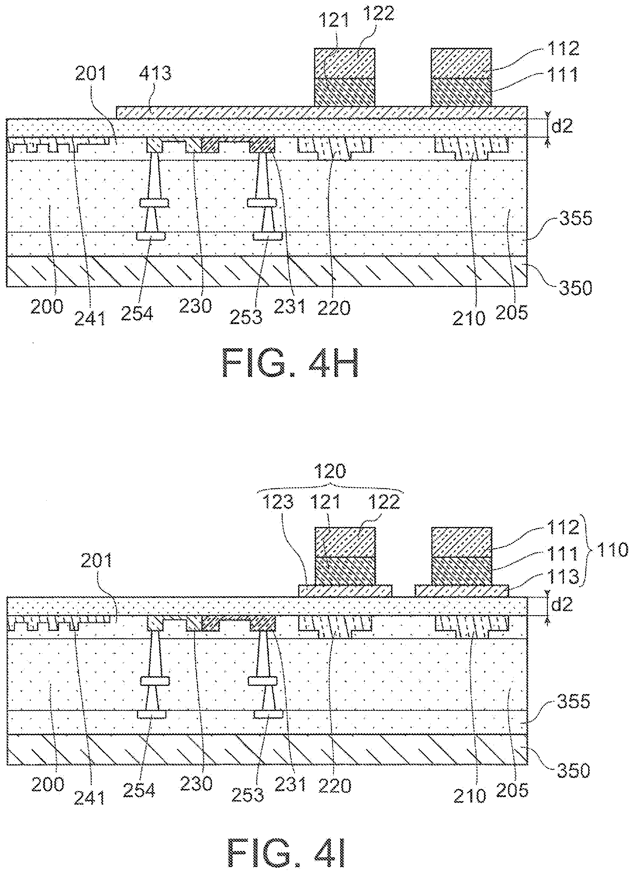

- les figures 4A à 4M illustrent schématiquement en coupe longitudinale les principales étapes de fabrication d'un module d'émission selon un troisième mode de réalisation de l'invention dans lequel le premier module d'émission et le premier guide d'onde présente une configuration notamment adaptée pour un couplage optique par transformation de modes adiabatique,

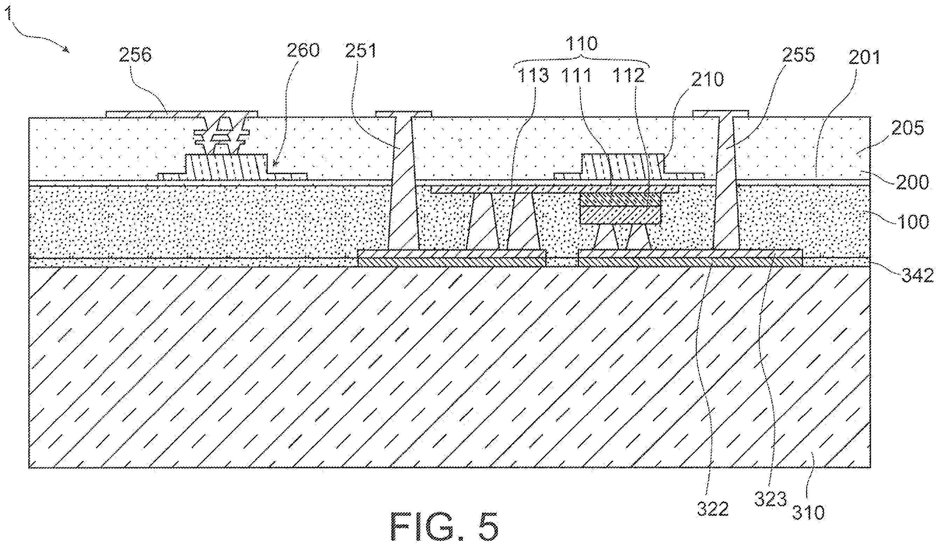

- la figure 5 illustre schématiquement en coupe longitudinale un composant laser semiconducteur hybride selon un quatrième mode de réalisation dans laquelle il est prévu un renvoi des interconnexions du module d'émission,

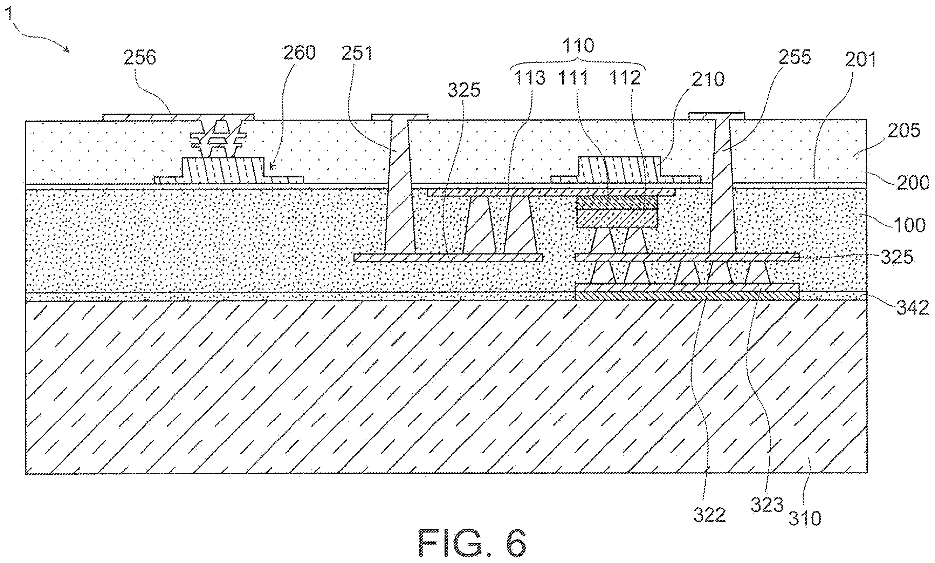

- la figure 6 illustre schématiquement en coupe longitudinale un composant laser semiconducteur hybride selon un cinquième mode de réalisation qui se différencie d'un composant laser selon le quatrième mode de réalisation en ce que la première et la deuxième interconnexion du module d'émission présente un renvoi sur un premier niveau d'interconnexion intermédiaire à une deuxième couche métallique du composant,

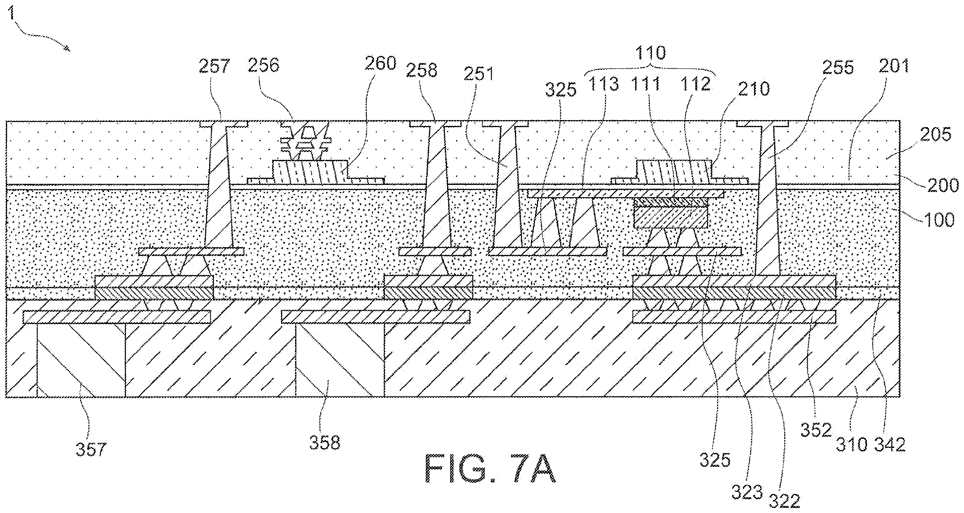

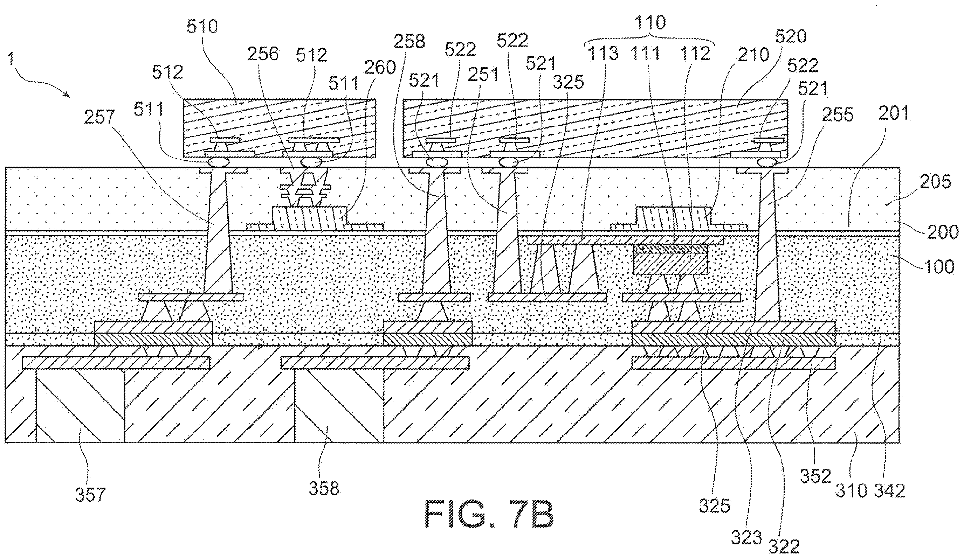

- les figures 7A et 7B illustrent schématiquement et en coupe longitudinale un composant laser semiconducteur hybride selon un sixième mode de réalisation qui se différencie d'un composant laser semiconducteur hybride selon le cinquième mode de réalisation en ce qu'il est prévu des via conducteurs traversant la couche de dissipation afin de permettre de contacter une électronique de commande au travers de la couche de dissipation.

On notera que l'ensemble des vues en coupe longitudinale des figures 1 à 4N, la coupe est réalisée selon une direction perpendiculaire à la direction de propagation de la lumière dans les guides d'onde et les cavités laser.

Des parties identiques, similaires ou équivalentes des différentes figures portent les mêmes références numériques de façon à faciliter le passage d'une figure à l'autre.

Les différentes parties représentées sur les figures ne sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La figure 1 illustre schématiquement un composant laser semiconducteur hybride 1 selon l'invention dans le cadre de son intégration dans un système photonique basé sur le silicium.

Un tel composant laser semiconducteur hybride 1 comporte :
- un premier et un deuxième module d'émission 110, 120 comprenant chacun une zone active 111, 121 réalisée en matériaux semiconducteurs à gap direct, tels que des semiconducteurs III-V, et conformée pour émettre un rayonnement électromagnétique à une longueur d'onde donnée,
- une couche optique 200 comprenant un premier et un deuxième guide d'onde 210, 220 couplés optiquement à respectivement la zone active 111, 121 du premier et du deuxième module d'émission 110, 120, chaque guide d'onde 210, 220 formant avec la zone active 111, 121 correspondante une cavité optique résonnante à la longueur d'onde donnée,
- une couche semiconductrice de dissipation thermique 310 en contact thermique avec les premier et deuxième modules d'émission 110, 120 sur une surface du premier et du deuxième module d'émission 110, 120 qui est opposée à la couche optique 200.

Pour fournir une masse commune au premier et au deuxième module d'émission 110, 120, le composant laser semiconducteur hybride 1 comporte également, en contact avec la couche semiconductrice de dissipation thermique 310 sur une face opposée au premier et deuxième module d'émission 110, 120, une première couche métallique 321 de masse commune.

La première couche métallique 321 est réalisée dans un matériau métallique adapté pour fournir un contact ohmique avec la couche semiconductrice de dissipation thermique 310. Ainsi, la première couche métallique 321 peut être une couche de tungstène W.

La couche semiconductrice de dissipation thermique 310 est une couche réalisée dans un matériau semiconducteur, tel que du silicium. Selon une possibilité préférée de l'invention et afin de contacter électriquement le contact de masse fourni par la première couche métallique 321 avec le premier et le deuxième module d'émission 110, 120, la couche semiconductrice de dissipation thermique 310 peut présenter une résistivité en ohm.cm inférieure à 9 ohm.cm, voire 4 ohm.cm, jusqu'à 0,002 ohm.cm. Elle peut dont être dopée de type N (au moyen d'élément dopant donneur d'élection tel que l'antimoine Sb) ou P (au moyen d'élément dopant accepteur d'électron tel que le Bore B) La couche semiconductrice de dissipation thermique présente préférentiellement une épaisseur comprise entre 700 µm et 50 µm, de manière encore plus avantageuse entre 500 µm et 150 µm, voire sensiblement égale à 100 µm.

Afin d'assurer le contact électrique et thermique entre la couche semiconductrice de dissipation thermique 310 et le premier et deuxième module d'émission 110, 120, le composant laser semiconducteur hybride 1 comporte également une deuxième, une troisième et une quatrième couche métallique 322, 323, 324.

Ainsi la couche semiconductrice de dissipation thermique 310 est en contact, sur une face qui est en regard du premier et du deuxième module d'émission 110, 120 avec la deuxième couche métallique. La deuxième couche métallique est réalisée dans un métal autorisant un collage moléculaire métallique. Dans un exemple de réalisation, la deuxième couche métallique peut être réalisée en tungstène W.

La deuxième couche métallique 322 est en contact, sur une face qui est opposée à la couche semiconductrice 310, avec la troisième couche métallique 323. Afin d'autoriser un collage moléculaire métallique, la troisième couche métallique 323 est réalisée dans le même métal que la deuxième couche métallique 322. Ainsi selon l'exemple de réalisation, la troisième couche métallique peut également être réalisée en tungstène W. On notera de même, que s'il est fait mention dans cette description d'une troisième et quatrième couche métallique 323, 324, le procédé de collage moléculaire utilisé dans le cadre de ce premier mode de réalisation permet de fournir une deuxième et troisième couche métallique 322, 323 qui se confondent en une seule couche métallique que l'on pourrait qualifier de « deuxième couche métallique ». Néanmoins, afin de faciliter l'entendement et le lien entre le composant laser semiconducteur hybride 1 et son procédé de fabrication, il est fait mention ci-dessus et dans le reste de ce document d'une troisième et d'une quatrième couche métallique 323, 324.

La troisième couche métallique 323 est en contact, sur une face qui est opposée à la deuxième couche métallique 322, avec la quatrième couche métallique 324. La quatrième couche métallique est adaptée pour fournir un contact ohmique avec le premier et le deuxième module d'émission 110, 120. Ainsi dans un exemple de réalisation dans lequel le premier et le deuxième module d'émission 110, 120 sont des modules d'émission dont la première et la deuxième zones 112 et 122 sont réalisées en phosphore d'indium InP dopé P, la quatrième couche métallique 324 est une couche de contact métallique ohmique adaptée pour le phosphore d'indium InP dopé P . Ainsi, la quatrième couche métallique 324 peut être par exemple une couche de platine Pt. La quatrième couche métallique 324 peut présenter une épaisseur comprise entre le 5 et 40 nm, préférentiellement entre 10 et 20 nm. De cette manière, l'épaisseur totale de la troisième et de la quatrième couche métallique 323, 324 peut être comprise entre 30 et 70 nm et être préférentiellement comprise entre 40 et 60 nm en étant avantageusement égale à 50 nm.

La quatrième couche métallique 324 est en contact avec le premier et le deuxième module d'émission 110, 120 sur une de leur face qui est opposée à la couche optique 200.

Le premier et le deuxième module d'émission 110, 120 sont tous deux inclus dans une couche d'encapsulation 100. La couche d'encapsulation 100 est réalisée dans un matériau isolant électrique, par exemple du nitrure de silicium SiN ou du dioxyde de silicium SiO₂. Une telle couche d'encapsulation 100 permet de passiver les flancs du premier et du deuxième module d'émission 110, 120, tout en leur permettant de présenter une surface sensiblement plane pour leur connexion. Ainsi le premier et le deuxième module d'émission 110, 120 affleure de préférence sur chacune des faces de la couche d'encapsulation 100.

La quatrième couche métallique 324 est également en contact avec la couche d'encapsulation 100.

Selon l'application pratique, le premier et le deuxième module d'émission 110, 120 comportent chacun :
- une première zone 112, 122 réalisée en phosphore d'indium InP et dopée P, ladite première zone 111, 121 affleurant la couche d'encapsulation 100 en contact avec la quatrième couche métallique 324,
- la zone active 111, 121, comporte soit une pluralité de puits quantiques conformés pour émettre un rayonnement électromagnétique à la longueur d'onde donnée, lesdits puits quantiques étant formés par un empilement de couches semiconductrices en matériaux semiconducteurs à gap direct tels qu'un empilement de couches d'arséniure-phosphure de gallium-indium InGaAsP et de couche d'arséniure de gallium-indium-aluminium InGaAIAs, ou soit, une pluralité de boîtes quantiques réalisées dans l'un parmi un arséniure-phosphure de gallium-indium InGaAsP et un arséniure de gallium-indium-aluminium InGaAIAs,
- une troisième zone 113, 123 réalisée en phosphore d'indium InP et dopée N, ladite troisième zone 113, 123 affleurant la couche d'encapsulation 100 en contact avec la couche optique 200 en fournissant un couplage optique entre les zones actives 111, 121 et les guides d'onde 210, 220 correspondants.

Les matériaux de la première zone 112, 122, de la zone active 111, 121 et de la troisième zone 113, 123 indiqués ci-dessus ne sont donnés qu'à titre d'exemple et peuvent être substitués pas d'autres matériaux sans que l'on sorte du cadre de l'invention. Ainsi par exemple, chacun des premier et deuxième modules d'émission 110, 120 peut comporter une première zone 111, 121 réalisée en arséniure de gallium GaAs et dopée P, une zone active 112, 122 formée de puis quantiques ou de boîtes quantiques en arséniure d'aluminium-gallium AIGaAs, et une troisième zone 113, 123 réalisée en arséniure de gallium GaAs et dopée N.

Avec une telle configuration du premier et du deuxième module d'émission dans la couche d'encapsulation, le couplage optique entre chacune des première et deuxième zones actives 111, 121 et le guide d'onde 210, 220 correspondant peut être un couplage du type évanescent ou adiabatique

La couche d'encapsulation 100 est également en contact, sur la face opposée à la quatrième couche métallique 324, avec la couche optique 200.

Selon l'exemple de réalisation illustré sur la figure 1, la couche optique 200 comprend :
- le premier et le deuxième guide d'onde 210, 220,
- un modulateur 230 constitué par un guide d'onde comprenant une jonction semiconductrice PN afin de permettre une modification de son indice effectif de réfraction,
- un sortie optique 240 latérale afin d'autoriser un couplage optique du type « par la tranche »,
- une première, une deuxième, une troisième et une quatrième interconnexion 251, 252,253, 254 afin de connecter, pour la première et la deuxième interconnexion 251, 252, le premier et le deuxième module d'émission 110, 120 et, pour la troisième et la quatrième interconnexion 253, 254 la première et la deuxième zone semiconductrice 231, 232 de la jonction semiconductrice PN du modulateur 230
- un matériau de remplissage 205 enfermant le premier et le deuxième guide d'onde 210, 220, le modulateur 230, la sortie optique 240 et les interconnexions 251, 252, 253, les interconnexions251, 252, 253 affleurant le matériau de remplissage 205.

Bien entendu, en variante à la sortie optique 240 latérale représentée sur la figure 1, il est également envisageable de prévoir une sortie optique surfacique au moyen d'un réseau de couplage surfacique. Une telle possibilité est connue de l'homme du métier et est décrite dans le cadre des figures 4A à 4L.

De la même façon et bien entendu, si seules quatre interconnexions 251, 252, 253, 254 sont représentées, un composant laser semiconducteur hybride 1 selon l'invention peut en comporter un nombre supérieur, ou inférieur, sans que l'on sorte du cadre de l'invention.

Une telle couche optique 200 forme un système photonique à base de silicium et peut ainsi intégrer des composants optiques tels qu'un modulateur optique du type Mach-Zehnder ou du type anneau résonnant. On notera que, plus précisément, le premier et le deuxième guide d'onde et le modulateur sont compris dans une sous-couche de guidage 221 de la couche optique.

Selon cet exemple de réalisation, le premier et le deuxième guide d'onde 210, 220, et le modulateur 230 sont tous trois réalisés en silicium Si. Plus précisément, le premier et le deuxième guide d'onde 210, 220 sont réalisés dans un silicium pas ou peu dopé, c'est-à-dire préférentiellement intrinsèque, et le modulateur 230 inclus une première et une deuxième zone semiconductrice 231, 232, l'une dopée N, l'autre dopée P, formant une jonction semiconductrice pour former un modulateur connu de l'homme de l'art (jonction semiconductrice PN formée dans un guide d'onde perpendiculairement à la direction de propagation de la lumière).

Le premier et le deuxième guide d'onde 210, 220 sont tous deux disposés à proximité de la face de la couche optique 200 qui est en contact avec la couche d'encapsulation 100 ceci de manière à ce que le premier et le deuxième guide d'onde 210, 220 soient couplés optiquement à la zone active 111, 121 respective du premier et du deuxième guide d'onde 210, 220. Un tel couplage optique entre les premier et deuxième guides d'onde 210, 220 et les zones actives du premier et du deuxième module d'émission 110, 120 permet de former une première et une deuxième cavité optique résonnante à la longueur d'onde donnée. Ces première et deuxième cavités optiques résonnantes à la longueur d'onde donnée forment respectivement une première et une deuxième cavité laser.

La première et la deuxième interconnexion 251, 252 s'étendent sur toute l'épaisseur de la couche optique 200 afin de contacter les deuxièmes zones 113, 123 de respectivement le premier et le deuxième module d'émission 110, 120. De la même façon les troisième et quatrième interconnexions 253, 254 s'étendent sur une partie de l'épaisseur de la couche optique 200 afin de contacter respectivement la deuxième et la première zone semiconductrice 232 du troisième guide d'onde afin de permettre une modulation de l'indice effectif de réfraction du guide d'onde du modulateur 230.

Ainsi, avec une telle configuration du composant laser hybride 1, le premier et le deuxième module d'émission 110, 120 sont tous deux en contact thermique et électrique par leur deuxième zone 113, 123 respective avec la couche semiconductrice de dissipation thermique 310 ceci au moyen des deuxième, troisième et quatrième couches métalliques 322, 323, 324. Le premier et le deuxième modules d'émission 110, 120 présentent donc une masse commune fournie par la couche semiconductrice de dissipation thermique 310 et sont polarisées respectivement par la première et la deuxième interconnexion 251, 252.

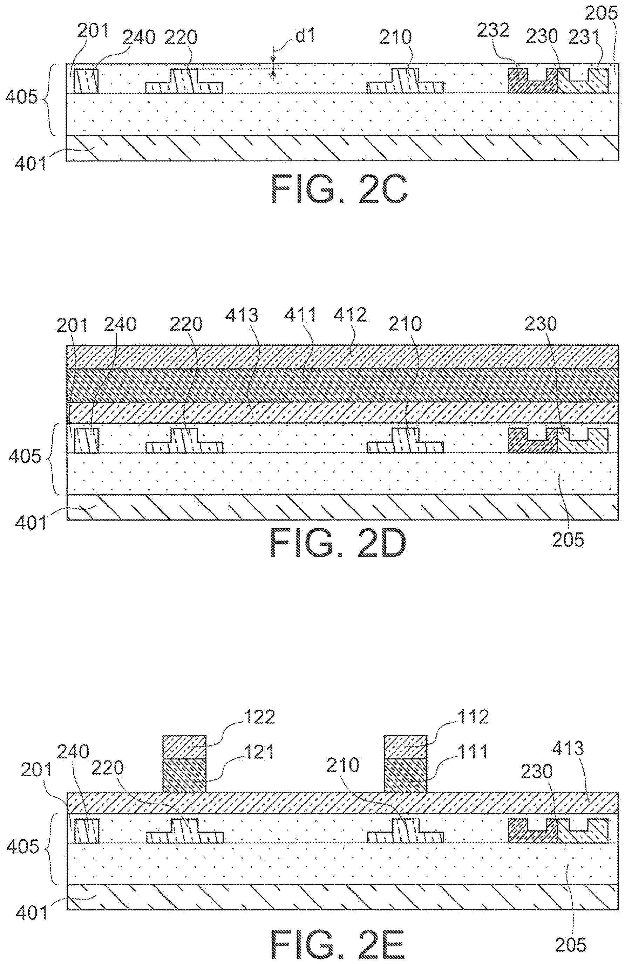

Le laser semiconducteur hybride 1 selon la réalisation pratique de ce premier mode de réalisation peut être, en référence aux figures 2A à 2M, fabriqué par un procédé de fabrication comportant les étapes suivantes :
- fourniture d'un substrat semiconducteur du type silicium sur isolant, ledit substrat comportant un premier support silicium 401 surmonté d'une couche de dioxyde de silicium 402 elle-même surmontée d'une couche de silicium 403 comme illustré sur la figure 2A,
- formation dans la couche de silicium 403, par gravure et implantation, du premier et deuxième et troisième guide d'onde 210, 220, du modulateur 230 et de la sortie optique 240, le reste de la couche silicium étant supprimé par la gravure, comme illustré sur la figure 2B,
- encapsulation des premier, deuxième guides d'onde 210, 220, du modulateur 230 et de la sortie optique 240 par le matériau de remplissage 205 isolant, par exemple du dioxyde de silicium, suivi par une planarisation du matériau de remplissage, ceci de manière à former une première partie 405 de la couche optique 200 comprenant la sous-couche de guidage 201, le premier et le deuxième guide d'onde 210, 220 étant à une distance d1 de la face de ladite première partie 405 opposée au support silicium 401 qui est compatible avec un couplage optique du type évanescent ou adiabatique, comme illustré sur la figure 2C,

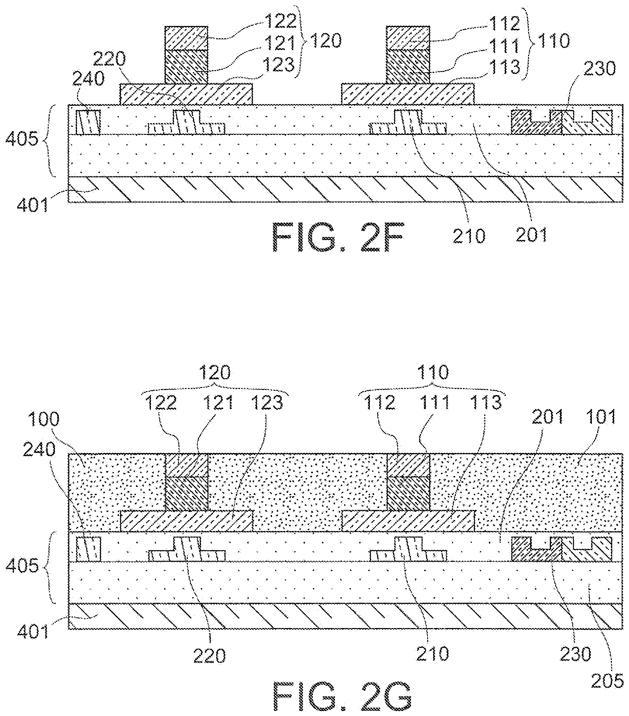

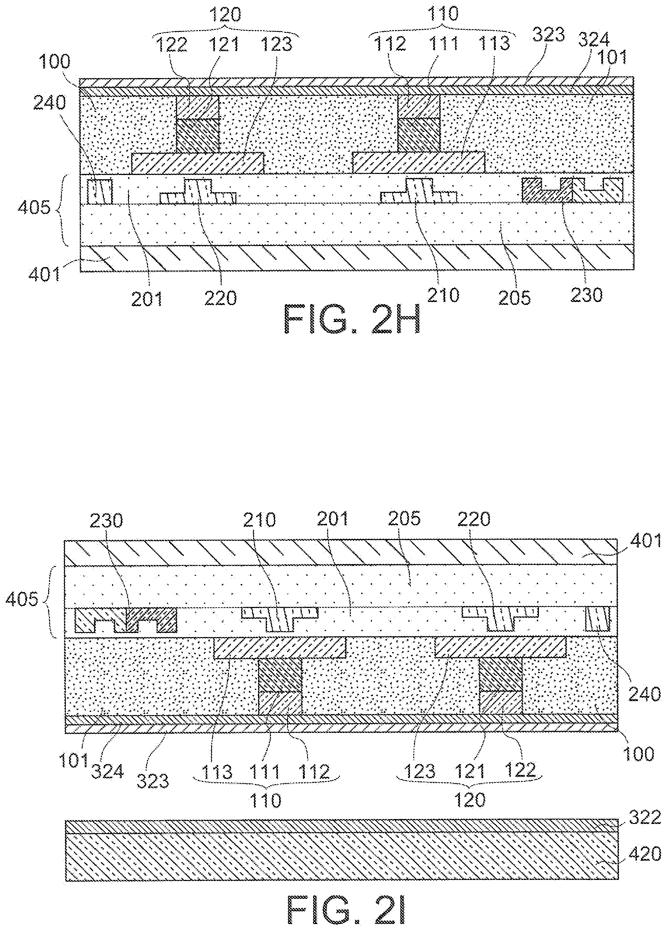

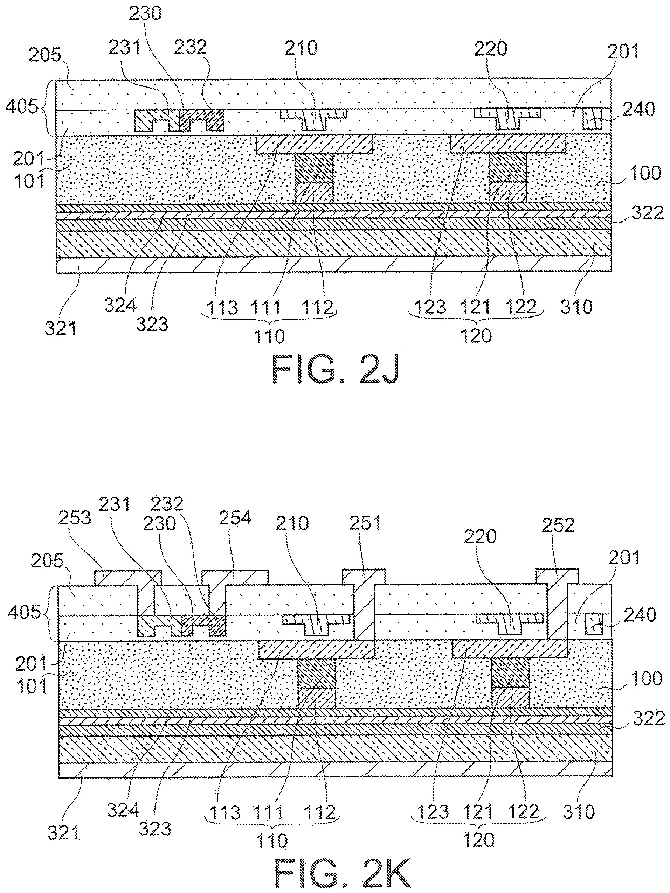

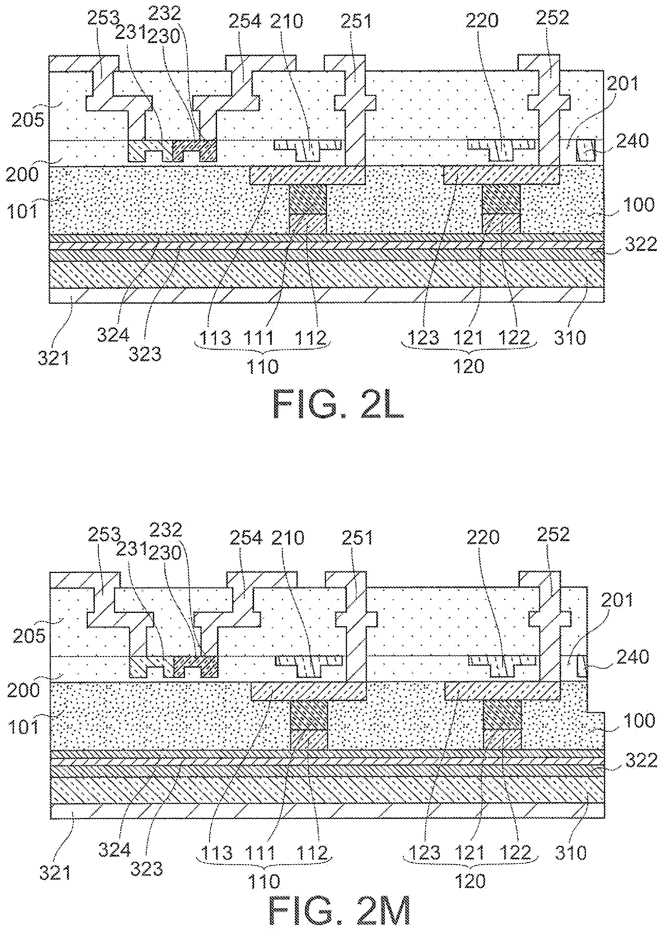

- formation, en contact de la face de la première partie 405 qui est opposée au support silicium 401, d'un empilement de couches composé d'une première couche de phosphore d'indium 413 dopée N, d'une couche active 411 comportant une pluralité de puits quantiques ou de boîtes quantiques et d'une deuxième couche de phosphore d'indium 412 dopée P, comme illustré sur la figure 2D,
- gravure de la deuxième couche de phosphore d'indium 412 et de la couche active 411 afin de former respectivement les premières zones 112, 122 et les zones actives 111, 121 du premier et du deuxième module d'émission 110, 120, le reste de la deuxième couche de phosphore d'indium 412 et de la couche active 411 étant supprimé lors de cette gravure, comme illustré sur la figure 2E,
- gravure de la première couche de phosphore d'indium 413 afin de former respectivement les deuxièmes zones 113, 123 du premier et du deuxième module d'émission 110, 120 et ainsi former le premier et le deuxième module d'émission 110, 120, comme illustré sur la figure 2F,
- encapsulation du premier et du deuxième module d'émission dans un matériau isolant, par exemple du nitrure de silicium SiN ou du dioxyde de silicium SiO₂ ceci afin de former la couche d'encapsulation 100, et planarisation dudit matériau isolant ceci afin de faire affleurer les premières zones 112, 122 de chacun du premier et du deuxième module d'émission 110,120, comme illustré sur la figure 2G,
- dépôt successif de la quatrième et de la troisième couche métallique 324, 323 en contact de respectivement la couche d'encapsulation 100 et la quatrième couche métallique 324, la quatrième couche métallique 324 étant en contact électrique et thermique avec la première zone 112, 122 des premier et deuxième module d'émission 110, 120, comme illustré sur la figure 2H,
- fourniture d'un deuxième support silicium 420 sur lequel la deuxième couche métallique 322 a été préalablement déposée, comme illustré sur la figure 2I,
- collage moléculaire métallique des deuxième et troisième couches métalliques 322, 323, comme illustré sur la figure 2J,
- retrait du support silicium 401,
- formation d'une première couche d'interconnexion 431, les premières portions des première, deuxième et, troisième et quatrième interconnexions 251, 252, 253, 254 étant alors formées en contact de respectivement le premier et le deuxième module d'émission 110, 120, de chacune de la première et la deuxième zone semiconductrice 231, 232 du modulateur 230, comme illustré sur la figure 2K,
- formation d'une deuxième couche d'interconnexion 432, une deuxième portion des première, deuxième, troisième et quatrième interconnexions 251, 252, 253, 254 de manière à former la première, la deuxième, la troisième, et quatrième interconnexion 251, 252, 253, 254 et la couche optique 200, comme illustré sur la figure 2L,
- gravure d'une portion latérale de la couche optique 200 et de la couche d'encapsulation 100 afin de fournir un accès latéral à la sortie optique 240 et ainsi autoriser un couplage optique par la tranche, comme illustré sur la figure 2M
- amincissement du deuxième substrat pour former la couche semiconductrice de dissipation thermique 310,
- formation de la première couche métallique 321 sur la face de la couche semiconductrice de dissipation thermique 310 qui est opposée à la couche optique 200 pour ainsi former le composant laser hybride comme illustré sur la figure 1.

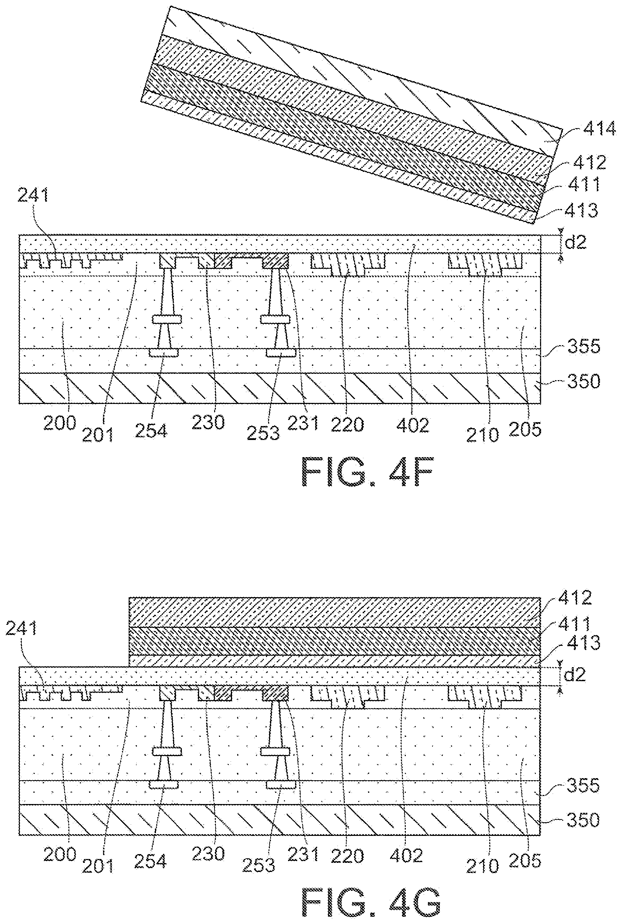

L'étape de formation, en contact de la face de la première partie 405 qui est opposée au support silicium 401, d'un empilement de couches composé d'une première couche de phosphore d'indium 413 dopée N, d'une couche active 411 comportant une pluralité de puits quantiques ou de boîtes quantiques et d'une deuxième couche de phosphore d'indium 412 dopée P, peut être réalisée par le dépôt épitaxial successif de la première couche de phosphore d'indium 413, de la couche active 411 et de la deuxième couche de phosphore d'indium 412. En variante, une telle étape de formation peut également être mise en œuvre par collage d'un substrat comportant la premiere couche de phosphore d'indium 413, la couche active 411 et la deuxième couche de phosphore d'indium 412 et une suppression du support portant lesdites couches. Il est à noter que c'est cette possibilité qui est décrite ci-après en lien avec le troisième mode de réalisation et les figures 4G et 4H.

Il est également à noter que l'étape de gravure d'une portion latérale de la couche optique 200 et de la couche d'encapsulation 100 est réalisée dans le but d'un couplage par la tranche. Ainsi dans le cas où il n'est pas prévu de couplage optique ou que le couplage optique est autre qu'un couplage optique par la tranche, cette étape n'est bien entendu pas mise en œuvre et peut être substituée à une étape de formation d'un élément de couplage autre, tel qu'un réseau de couplage surfacique.

Afin d'assurer un couplage optique évanescent, la distance d1 entre chaque module d'émission 110, 120 et le guide d'onde 210, 220 correspondant est comprise entre 1 à 200 nm.

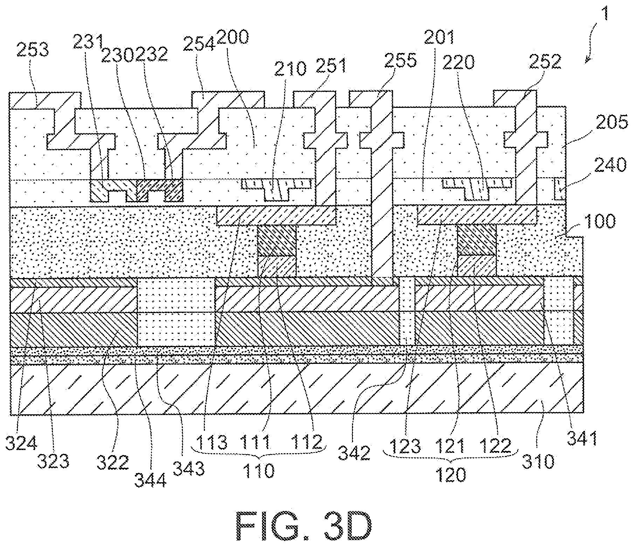

La figure 3D illustre un composant laser semiconducteur hybride 1 selon un deuxième mode de réalisation de l'invention dans lequel il n'est pas prévu de contact électrique de masse commune, l'ensemble des connexions étant fourni au moyen d'interconnexions 251, 252, 253, 254, 255 traversant la couche optique 200. Un composant laser semiconducteur hybride 1 selon ce deuxième mode de réalisation se différencie du composant laser semiconducteur hybride 1 selon le premier mode de réalisation en ce que les deuxième, troisième et quatrième couches métalliques 322, 323, 324 sont divisées en plusieurs zones d'interconnexion au moyen de barrières isolantes 241, 242 et en ce que ces mêmes deuxième, troisième et quatrième couches métalliques 322, 323, 324 sont isolées électriquement tout en étant mises en contact thermique avec la couche semiconductrice de dissipation thermique 310 au moyen d'une première et d'une deuxième couches d'isolation électriques 343, 344.

Ainsi dans ce deuxième mode de réalisation, les deuxième, troisième et quatrième couches métalliques 322, 323, 324 forment, de par les barrières isolantes 241, 242, une couche d'interconnexion pour connecter les premières zones 212, 222 de chacun du premier et du deuxième module d'émission 110, 120. Afin de connecter cette couche d'interconnexion formée par les deuxième, troisième et quatrième couches métalliques 322, 323, 324, le composant comporte des interconnexions 255 traversant la couche d'encapsulation 100 et la couche optique 200. De cette manière, l'ensemble des connexions du composant semiconducteur hybride est disponible sur la face de la couche optique 200 qui est opposée à la couche semiconductrice de dissipation thermique 310.

On notera que, par soucis de concision, seule une cinquième interconnexion 255 est illustrée pour la fourniture du contact de masse du premier module d'émission 110. Bien entendu, si l'interconnexion pour la fourniture du contact de masse du deuxième module d'émission 120 n'est pas représentée sur la figure 3D, elle néanmoins présente afin d'assurer la polarisation du deuxième module d'émission 120 ceci avec une configuration similaire à celle de la cinquième interconnexion 255.

Dans le cadre d'une application pratique de l'invention, de la même façon que dans le premier mode de réalisation, la quatrième couche métallique 324 peut être par exemple une couche de platine Pt. La troisième et la deuxième couche métallique 322, 323 sont réalisées en cuivre pour fournir un collage hybride cuivre/isolant tel que décrit par Y. Beilliard *et al.* dans leurs travaux présentés dans le cadre de la conférence « 3D Systems Integration Conférence » du 2 au 4 octobre 2013 et publiés en tant qu'acte de conférence le 9 Janvier 2014 sous le titre anglais « Chip to wafer copper direct bonding electrical characterization and thermal cycling ».

Les barrières isolantes 341, 342 sont formées, pour une première partie 341, dans la quatrième et troisième couche métallique 323, 324, et pour une deuxième partie 342, dans la deuxième couche métallique 322. La première partie 341 des barrières isolantes 341, 342 est conforme à la deuxième partie 342 de manière à éviter tout court-circuit entre les zones d'interconnexion formées dans les deuxième, troisième et quatrième couches métalliques 322, 323, 324. Selon l'application pratique de l'invention, les barrières isolantes 341, 342 peuvent être réalisées en dioxyde de silicium SiO₂

La première et la deuxième couche d'isolation électrique343, 344 sont respectivement réalisées en nitrure de silicium SiN et en dioxyde de silicium Si0₂. Afin de fournir un contact thermique entre la couche semiconductrice de dissipation thermique 310 et le premier et deuxième module d'émission 110, 120, la première et la deuxième couches d'isolation électriques 343, 344 présentent chacune une épaisseur comprise entre 10 et 50 nm, préférentiellement entre 15 et 30 nm et de manière avantageusement égale à 20 nm.

Ainsi, si on prend l'exemple donné lors de l'introduction de la définition de « contact thermique », à savoir un module laser présentant une surface de contact de 1 mm par 5 µm, la première couche d'isolation électrique343 présente ainsi une résistance thermique comprise entre 2.10⁻⁹ et 4.10⁻¹⁰ m².K.W¹ et la deuxième couche d'isolation électrique 344 présente une résistance thermique comprise entre 23.10⁹ et 8.10⁻⁹ m².K.W⁻¹. La résistance thermique cumulée de la première et la deuxième couche d'isolation électrique 343, 344 est comprise entre 25.10⁹ et 8,4.10⁻⁹ m².K.W⁻¹ et est donc inférieure à 3.10⁻⁸ m².K.W⁻¹.

Bien entendu, une telle configuration dans laquelle l'interface entre chaque module d'émission 110, 120 et la couche semiconductrice de dissipation thermique 310 est fournie par la première et la deuxième couche d'isolation électrique 343, 344 décrite ci-dessus est donnée qu'à titre d'exemple. Ainsi, un composant laser semiconducteur hybride 1 selon l'invention peut présenter une interface entre chaque module d'émission 110, 120 et la couche semiconductrice de dissipation thermique 310 fournie par un nombre de couche autre que deux et de matière différente sans que l'on sorte du cadre de l'invention tant que l'épaisseur de ladite ou desdites couches est adaptée pour que la résistance thermique entre la surface du premier module d'émission et la couche semiconductrice est inférieure à 1.10⁻⁷ m².K.W⁻¹, préférentiellement inférieure à 5.10⁻⁸ m².K.W¹ et encore plus avantageusement inférieure à 3.10⁻⁸ m².K.W⁻¹, voire 2.10⁻⁸ m².K.W⁻¹.

Selon une variante avantageuse au moins l'une de la première et la deuxième couche d'isolation électrique 343, 344 est réalisé dans un diélectrique High K. De cette manière il est possible de réduire l'épaisseur de ladite couche d'isolation électrique en gardant une isolation électrique adaptée.

Dans ce deuxième mode de réalisation la couche semiconductrice de dissipation thermique 310 est une couche de silicium intrinsèque et présente une épaisseur de 700 µm.

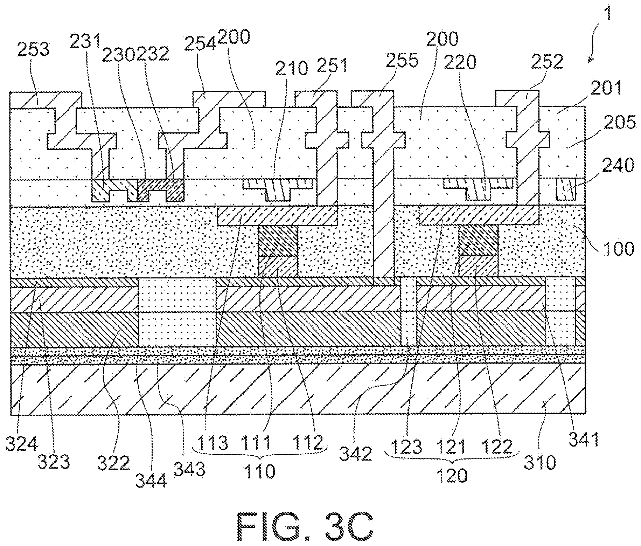

Le procédé de fabrication d'un composant laser semiconducteur hybride 1 selon ce deuxième mode de réalisation se différencie du procédé de fabrication d'un composant laser semiconducteur hybride 1 selon le premier mode de réalisation en ce qu'après l'étape de dépôt successif de la quatrième et de la troisième couche métallique 324, 323 en contact de respectivement la couche d'encapsulation 100 et la quatrième couche métallique 324, comme illustré sur la figure 2H, il est prévu les étapes suivantes :
- gravure localisée des troisième et quatrième couches métalliques 324, 323 de manière à former les zones d'interconnexion et dépôt de la première partie 341 des barrières isolantes 341, 342, comme illustré sur la figure 3A,
- fourniture de la couche semiconductrice de dissipation thermique 310, celle-ci présentant sur l'une de ces faces la deuxième couche métallique 322 sur laquelle les zones d'interconnexion ont été formée au moyen de la deuxième partie 342 des barrières isolantes 341, 342, comme illustré sur la figure 3B,
- collage hybride cuivre/isolant de la deuxième couche métallique 322 et la troisième couche métallique 323, telle qu'illustré sur la figure 3C,
- gravure d'une portion latérale de la couche optique 200 et de la couche d'encapsulation 100 afin de fournir un accès latéral à la sortie optique 240 et ainsi autoriser un couplage optique par la tranche, le composant laser semiconducteur hybride 1 étant ainsi formé, comme illustré sur la figure 3D.

La figure 4N illustre un composant laser semiconducteur hybride 1 selon un troisième mode de réalisation qui présente la particularité d'être obtenu selon un procédé de fabrication alternatif à celui décrit pour le composant laser semiconducteur hybride 1 selon le premier mode de réalisation et qui est adapté pour fournir un couplage optique adiabatique entre chaque modules d'émission 110, 120 et le guide d'onde 210, 220 correspondant par transformation de modes. Le composant laser semiconducteur hybride 1 selon ce troisième mode de réalisation se différencie d'un composant semiconducteur hybride 1 selon le premier mode de réalisation en ce que la couche optique 200 présente une conformation différente.

Bien entendu, le composant laser semiconducteur hybride 1 présente dans ce troisième mode de réalisation une configuration adaptée pour fournir un couplage optique adiabatique par transformation de modes entre chaque modules d'émission 110, 120 et le guide d'onde 210, 220 correspondant, une telle configuration est également compatible avec un couplage optique évanescent. Ainsi, en variante, le composant laser semiconducteur hybride 1 selon ce troisième mode de réalisation peut également présenter un couplage optique entre au moins l'un parmi le premier et le deuxième module d'émission 110, 120 et le guide d'onde 210, 220 correspondant du type évanescent.

Ainsi, la couche optique 200 selon ce troisième mode de réalisation comporte :
- un premier et un deuxième guide d'onde 210, 220,
- un modulateur 230,
- une première, deuxième, troisième et quatrième interconnexion 251, 252, 253, 254 pour connecter, pour la première et la deuxième interconnexion 251, 252, le premier et le deuxième module d'émission 110, 120, et pour les troisième et quatrième interconnexions 253, 254 les première et deuxième zones semiconductrices 231, 232 du modulateur,
- une sortie optique 241 par la surface prenant la forme d'un réseau optique afin de permettre de coupler le système photonique formé par la couche optique avec un élément extérieur ou à un autre guide d'onde
- un matériau de remplissage 205 enfermant le premier et le deuxième guide d'onde 210, 220, le modulateur 230 et la première à la quatrième interconnexion 251, 252, 253, 254.

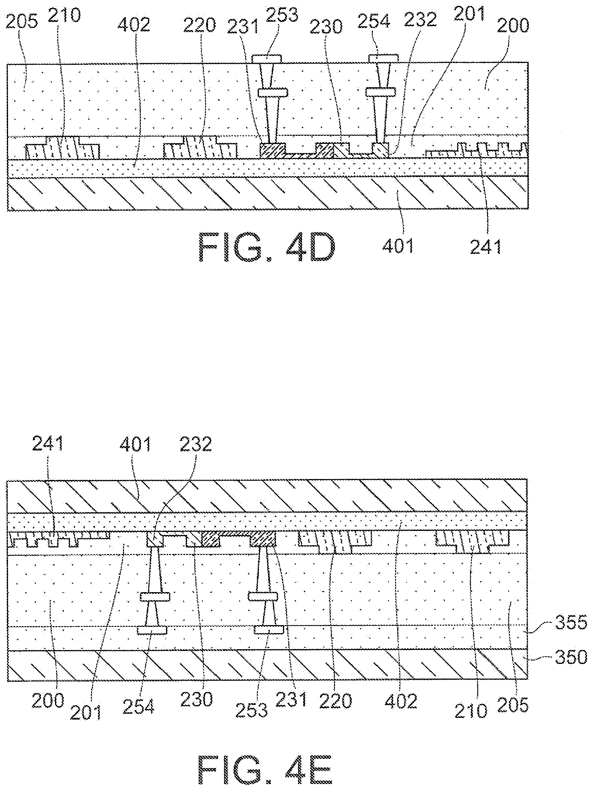

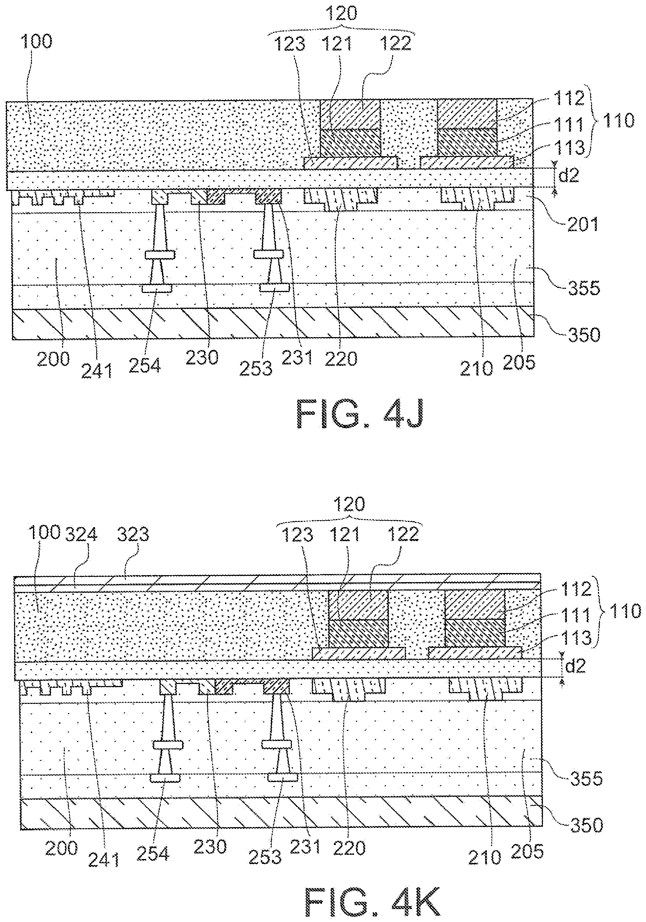

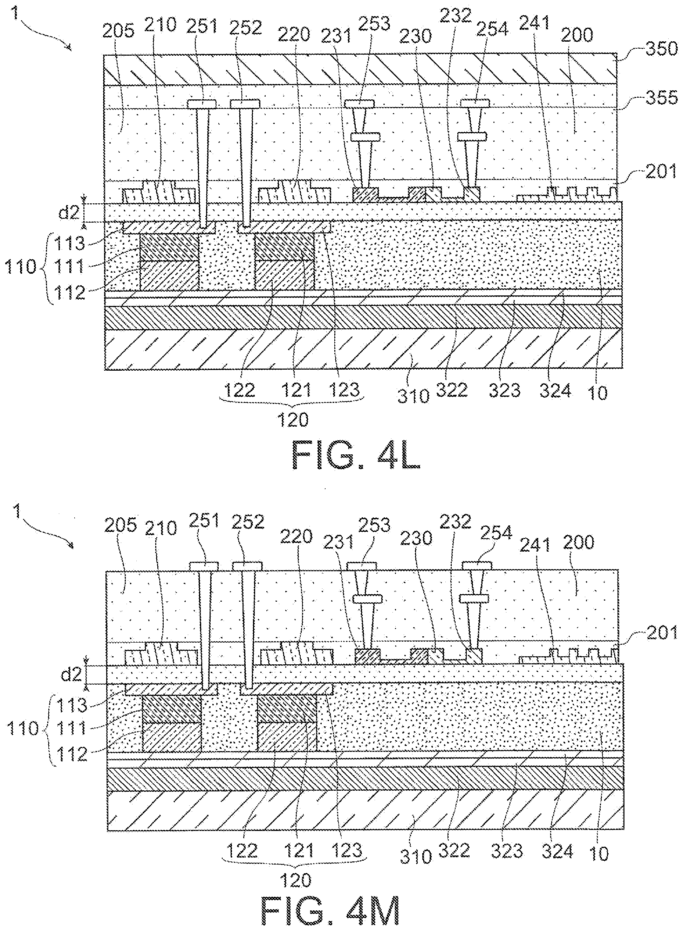

Un procédé de fabrication d'un composant laser semiconducteur hybride 1 selon ce troisième mode de réalisation comporte, en référence aux figures 4A à 4N, les étapes suivantes :
- fourniture d'un substrat du type semiconducteur isolant comportant un premier support 401, une couche d'isolant 402 et une couche de silicium,
- formation dans la couche de silicium, par gravure localisée et implantation, du premier et du deuxième guide d'onde 210, 220, du modulateur 230 et de la sortie optique 241, comme illustré sur la figure 4A,
- encapsulation du premier guide d'onde 210, du modulateur 230 et de la sortie optique 241 par le matériau de remplissage 205, c'est-à-dire du dioxyde de silicium, ceci de manière à former une première partie 405 de la couche optique 200, le premier et le deuxième guide d'onde 210, 220 étant à une distance d2 de la face de ladite première partie 405 opposée au support silicium 401, comme illustré sur la figure 4B,
- formation d'une première couche d'interconnexion 431, les premières portions d'une troisième et d'une quatrième interconnexion 253, 254 étant alors formées en contact de respectivement la première et la deuxième zone semiconductrice 231, 232 du modulateur 230, comme illustré sur la figure 4C,
- encapsulation des premières portions de la troisième et la quatrième interconnexion 253, 254 par le matériau de remplissage 205,
- formation d'une deuxième couche d'interconnexion 432, une deuxième portion des troisième et quatrième interconnexions 253, 254 de manière à former les troisième et quatrième interconnexions 253, 254 et la couche optique 200, comme illustré sur la figure 4D,
- encapsulation des deuxième portions des troisième et quatrième interconnexions 253, 254 par le matériau de remplissage 205 et planarisation afin de former une couche de collage 355, comme illustré sur la figure 4E,
- collage molléculaire de la couche de collage sur un substrat 350 dit de transport,
- retrait du support silicium 401, comme illustré sur la figure 4F,
- amincissement optionnelle de la couche d'isolant 402 afin de définir la distance d2 entre chaque module d'émission 110, 120 et le guide d'onde correspondant 210, 220,
- fourniture d'un troisième support semiconducteur 414 de phosphore d'indium InP comprenant sur l'une de ces faces une deuxième couche de phosphore d'indium 412, la deuxième couche de phosphore d'indium 412 étant recouverte d'une couche active 411 comportant une pluralité de puits quantiques, elle-même recouverte d'une première couche de phosphore d'indium 413,
- collage moléculaire de la première couche de phosphore d'indium 413 sur la couche d'isolant 402, comme qu'illustré sur la figure 4G
- retrait du troisième support semiconducteur 414,
- gravure de la deuxième couche de phosphore d'indium 412 et de la couche active 411 afin de former la première zone 112, 122 et la zone active 111, 121 du premier et du deuxième module d'émission 110, 120, le reste de la deuxième couche de phosphore d'indium 412 et de la couche active 411 étant supprimé lors de cette gravure, comme illustré sur la figure 4H,
- gravure de la première couche de phosphore d'indium 413 afin de former la deuxième zone 113, 123 du premier et du deuxième module d'émission 110, 120 et ainsi former le premier et le deuxième module d'émission 110, comme illustré sur la figure 4l,
- encapsulation du premier module d'émission 110 dans du nitrure de silicium SiN ou du dioxyde de silicium SiO₂ ceci afin de former la couche d'encapsulation 100, comme illustré sur la figure 4J,
- dépôt de la troisième et la quatrième couche métallique 323, 324 en contact de la couche d'encapsulation 100, la quatrième couche métallique 324 étant en contact avec la première zone 112 du premier module d'émission 110, comme illustré sur la figure 4K,
- fourniture d'un deuxième support silicium formant la couche semiconductrice de dissipation thermique 310, la deuxième couche métallique 322 ayant été préalablement déposée sur l'une des faces de ce deuxième support,
- collage moléculaire métallique du deuxième support silicium 420 au moyen des deuxième et troisième couches métalliques 322, 323, comme illustré sur la figure 4L,
- retrait du substrat de transport 350,
- suppression de la couche collage 355,
- formation d'une première et d'une deuxième interconnexion 251, 252 au travers de la couche optique 200 afin de connecter la deuxième zone 113, 223 du premier et du deuxième module d'émission 110, 120, comme illustré sur la figure 4M.

Dans ce troisième mode de réalisation la couche semiconductrice de dissipation thermique 310 est formée par le deuxième support semiconducteur et doit nécessairement présenter un contact non illustré afin de fournir la connexion de masse à la première zone 111 du premier module d'émission 110. Ce contact de masse peut être fourni, comme cela est le cas pour le composant laser semiconducteur hybride 1 selon le premier mode de réalisation, par des étapes, non illustrées, d'amincissement de la couche semiconductrice de dissipation thermique 310 et le dépôt d'une première couche métallique 321. Bien entendu, il est également envisageable de déposer directement une telle première couche de métallique en contact de la couche semiconductrice de dissipation thermique 310 sans étape préalable d'amincissement, voire en aménageant un simple plot de contact en contact de la couche semiconductrice de dissipation thermique 310.

On peut noter que, bien entendu, il est parfaitement envisageable de combiner les deuxième et troisième modes de réalisation, ceci sans que l'on sorte du cadre de l'invention. Un composant laser hybride 1 selon cette possibilité :
- ne comporte pas de masse commune mais présente un contact de masse indépendant pour chacun des modules d'émission 110, 120 conformément au troisième mode de réalisation, les troisième et quatrième couches métalliques 323, 324 étant divisées en plusieurs zones d'interconnexion au moyen de barrières isolantes,
- présente, en conformité avec le troisième mode de réalisation, une configuration adaptée pour fournir un couplage optique adiabatique entre chaque module d'émission 110, 120 et le guide d'onde 210, 220 correspondant par transformation de modes.

La figure 5 illustre un composant laser à semiconducteur hybride selon un quatrième mode de réalisation dans lequel les première et cinquième interconnexions 251, 255 du module d'émission sont ramenées sur des portions de deuxième et troisième couches métalliques 322, 323 en contact avec la couche semiconductrice de dissipation thermique 310 pour ensuite être retourner en direction de la couche optique 200 en la traversant.

Un composant laser à semiconducteur hybride selon ce quatrième mode de réalisation se différencie d'un composant laser à semiconducteur hybride selon le deuxième mode de réalisation en ce qu'il ne comporte qu'un seul module d'émission 210, en ce que la troisième zone semiconductrice 113 présente une extension s'étendant le long de la couche optique afin de permettre une prise de contact déportée vis-à-vis de la première interconnexion 251 et en ce que la première interconnexion 251 présente une configuration différente.

On notera également, qu'un composant actif 260 semiconducteur, tel qu'un modulateur, et une interconnexion 256 sont montrés sur la figure 5 ceci afin d'illustré la possibilité de loger des composants actif dans la couche optique 200.

Ainsi, comme le montre la figure 5, les première et troisième zones semiconductrices 112, 113 du premier module 110 sont polarisées au moyen de la première et la cinquième interconnexion 251,255. Chacune de la première et de la cinquième interconnexion 251, 255 présente :
- une première portion d'interconnexion s'étendant en direction de la couche semiconductrice de dissipation thermique 310,
- une portion respective de deuxième et troisième couches métalliques 322, 323, lesdites couches métalliques étant en contact avec la couche de dissipation,
- une deuxième portion d'interconnexion s'étendant dans la direction de la couche optique en la traversant et en débouchant au travers du matériau de remplissage 205 pour l'affleurer afin de permettre une connexion avec l'électronique de commande.

Dans ce quatrième mode de réalisation, afin d'éviter un court-circuit entre la première et la troisième zone semiconductrice 112, 113, les portions la couche semiconductrice de dissipation thermique est préférentiellement non intentionnellement dopée, voire faiblement dopée, et les portions de la deuxième et de la troisième couche métallique correspondant respectivement à la première et la deuxième interconnexion sont espacées les unes des autres d'une distance adaptée pour que la couche semiconductrice de dissipation thermique présente une résistance suffisante pour les isoler électriquement. Dans une configuration classique cette distance peut être supérieure à 15 µm, voire 30 µm ou encore 50 µm.

Dans ce quatrième mode de réalisation, la cinquième interconnexion 255 participe au contact thermique entre le premier module d'émission 110 et la couche semiconductrice de dissipation thermique 310.

Le procédé de fabrication d'un composant laser semiconducteur hybride 1 selon ce quatrième mode de réalisation se différencie d'un procédé de fabrication selon le premier mode de réalisation en ce que :
- lors de l'étape de fourniture de la couche optique, l'interconnexion 256 du composant actif 260 est formée,
- après l'étape d'encapsulation du premier module d'émission dans un matériau isolant il est formé une partie des premiere et cinquième interconnexions 251, 255, et les portions de la deuxième couche métallique 322,
- lors de l'étape de collage moléculaire métallique, la troisième couche métallique 323 présente les portions correspondantes à celles de la deuxième couche métallique 322.

La figure 6 illustre un composant laser semiconducteur hybride 1 selon un cinquième mode de réalisation dans lequel la première et la cinquième interconnexion 251, 255 du premier module d'émission présente un renvoi sur un premier niveau d'interconnexion intermédiaire à la deuxième et la troisième couche métallique.

Un composant laser semiconducteur hybride 1 selon ce cinquième mode de réalisation se différencie d'un composant selon le quatrième mode de réalisation en ce que la première et la cinquième interconnexion du module d'émission présente un renvoi sur un premier niveau d'interconnexion intermédiaire, la cinquième interconnexion 255 se prolongeant jusqu'à la deuxième couche métallique ceci afin de fournir le contact thermique entre le premier module d'émission 110 et la couche semiconductrice de dissipation thermique.

Ainsi dans ce cinquième mode de réalisation, le renvoi de la première et cinquième interconnexion 251, 255 est réalisé au niveau d'une quatrième couche métallique 325, c'est-à-dire un premier niveau d'interconnexion, selon un principe similaire à celui du quatrième mode de réalisation et la deuxième interconnexion présente, entre la quatrième couche métallique 325 et la deuxième couche métallique des via métalliques sur un deuxième niveau d'interconnexion. De tels via métalliques participent à la fourniture de la conduction thermique entre le premier module d'émission et la couche de dissipation thermique.

Un procédé de fabrication selon ce cinquième mode de réalisation se différencie du procédé de fabrication selon le quatrième mode de réalisation en ce que lors de l'étape de formation du reste de la première et de la cinquième interconnexion 251, 255, la quatrième couche métallique et les via de la cinquième interconnexion 255 sont formées, afin de fournir respectivement, le renvoi de la première et la cinquième interconnexion 251, 255 , et le contact thermique entre le premier module d'émission 110 et la couche semiconductrice de dissipation thermique 310.

Les figures 7A et 7B illustre un composant laser semiconducteur hybride 1 selon un sixième mode de réalisation dans lequel il est prévu des sixième et septième interconnexions traversantes 257, 357, 258, 358 entre une face externe du matériau de remplissage 205 et une face externe de la couche semiconductrice de dissipation thermique 310. Un tel composant laser semiconducteur hybride 1 selon ce sixième mode de réalisation se différencie d'un composant laser semiconducteur hybride 1 selon le cinquième mode de réalisation en ce qu'il est prévu les interconnexions traversantes 257, 357, 258, 358.

Comme montré sur la figure 7A, le composant comporte en outre, en plus des première et cinquième interconnexions 251, 255 et de l'interconnexion 256, une sixième et septième interconnexion traversante 257, 357, 258, 358 mettant en communication la face externe du matériau de remplissage 205 et la face externe de la couche semiconductrice de dissipation thermique 310. Ainsi la sixième et la septième interconnexion traversante 257, 357, 258, 358 comportent chacune :
- une première portion d'interconnexion 257, 258 s'étendant au travers du matériau de remplissage 205, la couche optique 200 et la couche d'encapsulation 100, ladite première portion d'interconnexion 257, 258 étant munie au niveau de la face externe du matériau de remplissage 205 d'un plot de contact respectif,
- une portion respective de deuxième et troisième couches métalliques 322, 323, lesdites couches métalliques étant en contact avec la couche semiconductrice de dissipation thermique 310,
- une deuxième portion d'interconnexion 357, 358 s'étendant au travers de la couche semiconductrice 310 de dissipation thermique et débouchant sur la face externe de la couche semiconductrice de dissipation thermique 310 sous la forme d'un plot de contact.

Ainsi, selon un principe similaire aux modes de réalisation précédents et comme illustré sur la figure 7B, il est possible de connecter des modules de commande 510, 520 de l'électronique de commande au module d'émission 110 et au composant actif 260 au moyen des plots de contact respectifs des première et cinquième interconnexions 251, 255 et de l'interconnexion 256. Une telle connexion peut être réalisée, par exemple et comme illustré sur la figure 7B, par hybridation par bille de cuivre 511, 512. Ces mêmes modules de commande 510, 520 sont, selon le principe de ce sixième mode de réalisation, eux même connectés aux sixième et septième interconnexions traversantes 257, 357, 258, 358 ceci au moyen les plots de connexion de ces dernières qui se trouvent au niveau de la surface externe du matériau de remplissage 205. Cette connexion peut être réalisée, par exemple, par hybridation par bille de cuivre. De cette manière les plots de connexion des deuxième portions d'interconnexion 357, 358 qui prolongent les sixième et septième interconnexion au niveau de la surface externe de la couche semiconductrice de dissipation thermique 310 fournissent une connexion extérieure des modules de commandes qui est accessible sur la couche semiconductrice de dissipation thermique 310 sur une face de cette dernière qui est opposée à la couche optique 200.

Bien entendu, dans ce sixième mode de réalisation de la même façon que dans le quatrième mode de réalisation, afin d'éviter un court-circuit entre les sixième et septième interconnexions traversantes 257, 357, 258, 358, la couche semiconductrice de dissipation thermique 310 est préférentiellement non intentionnellement dopée, voire faiblement dopée, et les portions de la deuxième et de la troisième couche métallique correspondant respectivement à la sixième et à la septième interconnexion traversante 257, 357, 258, 358 sont espacées les unes des autres d'une distance adaptée pour que la couche semiconductrice de dissipation thermique 310 présente une résistance suffisante pour les isoler électriquement. Dans une configuration classique cette distance peut être supérieure à 15 µm, voire 30 µm ou encore 50 µm.

On peut également noter que selon une possibilité de ce sixième mode de réalisation, la cinquième interconnexion 255 comporte une ligne d'interconnexion aménagée dans la couche de dissipation. Une telle ligne d'interconnexion fournie par une cinquième couche métallique permet d'optimiser la surface de contact entre la cinquième interconnexion 255 et la couche semiconductrice de dissipation thermique.

Un procédé de fabrication d'un composant se différencie d'une procédé de fabrication d'un composant selon le cinquième mode de réalisation en ce que lors de la fourniture de la couche semiconductrice de dissipation thermique 310, la couche semiconductrice de dissipation thermique 310 est fournie avec les deuxième portion d'interconnexion 357, 358 et en ce que les portions respective de deuxième et troisième couches métalliques 322, 323 des sixième et la septième interconnexion traversante 257, 357, 258, 358 sont formées dans lesdites deuxième et troisième couches métalliques.

Bien entendu, si dans les applications pratiques des six modes de réalisation décrites ci-dessus chacun des modules d'émission présente une première et une deuxième zone en phosphore d'indium, l'invention est compatible avec d'autre type de module d'émission, si tant est que ceux-ci sont pourvus de zones actives réalisées en matériaux semiconducteurs à gap direct, tels que des semiconducteurs III-V, et conformées pour émettre un rayonnement électromagnétique à une longueur d'onde donnée. Ainsi, il est parfaitement envisageable qu'un module d'émission présente, par exemple, une première et une deuxième zone en arséniure d'indium. Il est également envisageable que la zone active soit une zone comprenant des boites quantiques, voir une simple zone non intentionnellement dopée, ceci sans sortir du cadre de l'invention.

De la même façon, si les six modes de réalisation décrits ci-dessus, les composants laser hybride 1 sont des composants laser hybrides en relation avec une couche optique de systèmes photoniques non supportée par un support semiconducteur, les composants lasers hybride selon l'invention sont compatibles avec une couche optique supportée sur un support semiconducteur. Ainsi, un composant laser semiconducteur hybride selon l'invention peut parfaitement être intégré à un support non adapté, tel qu'un support silicium ou à un système photonique pourvu d'un support semiconducteur.

On notera que selon le principe de l'invention, dans l'ensemble des modes de réalisation décrit ci-dessus, au moins une partie des contacts des premier et deuxième modules d'émission 110, 120 et de l'ensembles des composants optiques actifs logés dans la couche optique 200 sont déportés sur une face opposée à la couche de dissipation thermique. Ainsi, il est possible d'optimiser la dissipation thermique du composant sans perturbation de la connexion du composant à l'électronique de commande.

## Revendications

1. Composant laser semiconducteur hybride (1) comportant :
- au moins un premier module d'émission (110, 120) comprenant une zone active (111, 121) réalisée en matériaux semiconducteurs à gap direct, tels que des semiconducteurs III-V, et conformée pour émettre un rayonnement électromagnétique à une première longueur d'onde donnée,
- une couche optique (200) comprenant au moins un premier guide d'onde (210, 220) couplé optiquement à la zone active (111, 121) de l'au moins un premier module d'émission (110, 120), le premier guide d'onde (210, 220) formant avec la zone active (111, 121) une cavité optique résonnante à la première longueur d'onde donnée,
le composant laser semiconducteur hybride (1) comportant en outre :
- une couche semiconductrice (310) dite de dissipation thermique, ladite couche semiconductrice de dissipation thermique (310) étant en contact thermique avec le premier module d'émission (110, 120) sur une surface du premier module d'émission (110, 120) qui est opposée à la couche optique (200)
le composant laser semiconducteur hybride étant **caractérisé en ce qu'**il comporte en outre
- au moins une première interconnexion (251, 252) pour connecter l'au moins un premier module d'émission, ladite première interconnexion (251,252) traversant la couche optique (200).

2. Composant laser semiconducteur hybride (1) selon la revendication 1, dans lequel le composant laser semiconducteur hybride (1) comprend en outre une deuxième interconnexion (255) pour connecter l'au moins un premier module d'émission, la deuxième interconnexion (255) étant en contact électrique avec la couche semiconductrice de dissipation thermique (310).

3. Composant laser semiconducteur hybride (1) selon la revendication 1, dans lequel le composant laser semiconducteur hybride (1) comprend en outre une deuxième interconnexion (255) pour connecter l'au moins un premier module d'émission, ladite deuxième interconnexion (255) traversant la couche optique (200), ladite deuxième interconnexion (255) comprenant préférentiellement :
- une première portion d'interconnexion s'étendant en direction de couche de dissipation thermique,
- une portion de couche métallique s'étendant sensiblement parallèlement à la couche semiconductrice de dissipation thermique (310), ladite portion étant en contact électrique avec la première portion d'interconnexion,
- une deuxième portion d'interconnexion s'étendant dans une direction opposée à la couche de dissipation thermique et traversant la couche optique (200), ladite deuxième portion d'interconnexion étant en contact électrique avec la portion de couche métallique.

4. Composant laser semiconducteur hybride (1) selon l'une quelconque des revendications 1 à 3 comprenant en outre :
- au moins un composant actif (260), tel qu'un modulateur optique, ledit composant actif (260) étant logé dans la couche optique (200),
- au moins une troisième interconnexion (256) pour connecter le composant actif, ladite troisième interconnexion s'étendant entre le composant actif (260) et une face du composant laser semiconducteur hybride (1) qui est opposée à la couche semiconductrice de dissipation thermique (310).

5. Composant laser semiconducteur hybride (1) selon l'une quelconque des revendications 1 à 4, dans lequel le composant comprend en outre au moins une quatrième interconnexion (257, 357, 258, 358) dite traversante, ladite quatrième interconnexion (257, 357, 258, 358) s'étendant entre une face du composant laser semiconducteur hybride (1) qui est opposée à la couche semiconductrice de dissipation thermique (310) et une face de la couche semiconductrice de dissipation thermique (310) qui est opposée à la couche optique (200),
et dans lequel ladite quatrième interconnexion (257, 357, 258, 358) présente sur chacune de ladite face du composant laser semiconducteur hybride (1) et de ladite face de la couche semiconductrice (310) un plot de contact respectif.

6. Composant laser semiconducteur hybride (1) selon l'une quelconque des revendications 1 à 5, dans lequel la couche semiconductrice de dissipation thermique (310) est une couche de silicium.

7. Composant laser semiconducteur hybride (1) selon l'une quelconque des revendications 1 à 6 comportant en outre au moins une première couche métallique (321) en contact avec la couche semiconductrice de dissipation thermique (310) sur une face de la couche semiconductrice de dissipation thermique (310) qui est opposée au premier module d'émission (110, 120).

8. Composant laser semiconducteur hybride (1) selon l'une quelconque des revendications 1 à 7 comprenant en outre au moins une deuxième couche métallique (322, 323, 324) en contact électrique avec le premier module d'émission sur la face du premier module d'émission (110, 120) qui est opposé à la couche optique (200),
et dans lequel la deuxième couche métallique (322, 323, 324) participe au contact thermique entre la couche semiconductrice de dissipation thermique (310) et le premier module d'émission (110, 120).

9. Composant laser semiconducteur hybride (1) selon la revendication 8 dans lequel la couche semiconductrice de dissipation thermique (310) est en contact électrique avec la deuxième couche métallique (322, 323, 324).

10. Composant laser semiconducteur hybride (1) selon la revendication 8 dans lequel il est prévu entre la deuxième couche métallique (322, 323, 324) et la couche semiconductrice de dissipation thermique (310) au moins une couche d'isolation électrique (343, 344) conformée pour isolé électriquement la deuxième couche métallique de la couche semiconductrice de dissipation thermique (310), la couche d'isolation électrique (343, 344) participant au contact thermique entre la couche semiconductrice de dissipation thermique (310) et le premier module d'émission (110, 120).

11. Composant laser semiconducteur hybride (1) selon l'une quelconque des revendications 1 à 10, dans lequel le premier module d'émission est inclus dans une couche d'encapsulation (100) réalisée dans un matériau isolant, tel que le nitrure de silicium ou le dioxyde de silicium.

12. Composant laser semiconducteur hybride (1) selon l'une quelconque des revendications 1 à 11 comprenant en outre au moins un deuxième module d'émission (120) comprenant une zone active (121) réalisée en matériaux semiconducteurs à gap direct, tels que des semiconducteurs III-V, et conformée pour émettre un rayonnement électromagnétique à une deuxième longueur d'onde donnée différente ou identique à la première longueur d'onde donnée,
dans lequel la couche optique (200) comprend en outre au moins un deuxième guide d'onde (220) couplé optiquement à la zone active (121) du deuxième module d'émission (120), ledit premier guide d'onde (220) formant avec la zone active (121) une cavité optique résonnante à la deuxième longueur d'onde donnée,
et dans lequel la couche semiconductrice de dissipation thermique (310) est en contact thermique avec le deuxième module d'émission (120) sur une surface du deuxième module d'émission (120) qui est opposée à la couche optique (200).

13. Procédé de fabrication d'un laser semiconducteur hybride (1), comportant les étapes suivantes :
- fourniture d'une couche optique (200) comportant au moins un premier guide d'onde (210, 220),
- fourniture d'au moins un premier module d'émission (110, 120) comprenant une zone active (111, 112) réalisée en matériaux semiconducteurs à gap direct, tels que des semiconducteurs III-V, et conformée pour émettre un rayonnement électromagnétique à une première longueur d'onde donnée, la zone active (111, 112) étant couplée optiquement avec le premier guide d'onde (210, 220) et formant avec le premier guide d'onde (210, 220) une cavité optique résonnante à la longueur d'onde donnée,
le procédé de fabrication comportant l'étape suivante :
- fourniture d'une couche semiconductrice (310) dite de de dissipation thermique, ladite couche semiconductrice de dissipation thermique (310) étant en contact thermique avec le premier module d'émission (110, 120) sur une surface du premier module d'émission (110, 120) qui est opposée à la couche optique (200), le procédé de fabrication étant **caractérisé en ce qu'** il est prévu une étape de formation d'au moins une première interconnexion (251, 252) pour connecter l'au moins premier module d'émission, ladite première interconnexion (251, 252) s'étendant en traversant la couche optique (200).

14. Procédé de fabrication selon la revendication 13, dans lequel l'étape de fourniture d'une couche semiconductrice de dissipation thermique (310) comprend les sous-étapes suivantes :
- formation d'au moins une deuxième couche métallique (322) en contact thermique avec le premier module d'émission (110, 120) sur la surface du premier module d'émission (110, 120) qui est opposée à la couche optique (200),
- fourniture de la couche semiconductrice de dissipation thermique (310),
- formation en contact thermique avec la couche semiconductrice de dissipation thermique (110, 120) d'une troisième couche métallique (323),
- collage moléculaire métallique de la deuxième couche métallique (322) avec la troisième couche métallique (323) de manière à mettre en contact thermique la surface du premier module d'émission qui est opposée à la couche optique et la couche semiconductrice de dissipation thermique en contact thermique.

15. Procédé de fabrication selon la revendication 13 dans lequel lors de l'étape de fourniture d'une couche semiconductrice de dissipation thermique (310) il est prévu entre la sous-étape de fourniture de la couche semiconductrice de dissipation thermique (310) et la sous-étape de formation de la troisième couche métallique (323), la sous-étape suivante
- formation d'au moins une moins une couche d'isolation électrique (343, 344) en contact thermique avec la couche semiconductrice de dissipation thermique (110, 120),
la couche d'isolation électrique (343, 344) étant conformée pour isoler électriquement la deuxième couche métallique (322) de la couche semiconductrice de dissipation thermique (310), la couche d'isolation électrique (343, 344) électrique participant au contact thermique entre la couche semiconductrice de dissipation thermique (310) et le premier module d'émission (110, 120).

16. Procédé de fabrication selon l'une quelconque des revendications 13 à 15, dans lequel lors de l'étape de fourniture de la couche optique (200), la couche optique comporte au moins un deuxième guide d'onde (220),
dans lequel lors de l'étape de fourniture de l'au moins un premier module d'émission il est également fourni un deuxième module d'émission, le deuxième module d'émission (120) comprenant une zone active (121) réalisée en matériaux semiconducteurs à gap direct, tels que des semiconducteurs III-V, et conformée pour émettre un rayonnement électromagnétique à une deuxième longueur d'onde donnée différente ou identique à la première longueur d'onde donnée,
et dans lequel lors de l'étape de fourniture de la couche semiconductrice de dissipation thermique(310), ladite couche semiconductrice de dissipation thermique (310) est également en contact thermique avec le deuxième module d'émission (120) sur une surface du deuxième module d'émission (110, 120) qui est opposée à la couche optique (200).

## Patentansprüche

1. Hybrid-Halbleiterlaser-Bauelement (1), enthaltend:
- zumindest ein erstes Emissionsmodul (110, 120), das einen aktiven Bereich (111, 121) enthält, der aus Halbleitermaterialien mit direkter Bandlücke, wie etwa III-V-Halbleitern, besteht und dazu ausgebildet ist, eine elektromagnetische Strahlung mit einer ersten gegebenen Wellenlänge zu emittieren,
- eine optische Schicht (200), die zumindest einen ersten Wellenleiter (210, 220) enthält, der optisch mit dem aktiven Bereich (111, 121) des zumindest einen ersten Emissionsmoduls (110, 120) gekoppelt ist, wobei der erste Wellenleiter (210, 220) mit dem aktiven Bereich (111, 121) einen optischen Resonanzhohlraum mit der ersten gegebenen Wellenlänge bildet,
wobei das Hybrid-Halbleiterlaser-Bauelement ferner enthält:
- eine wärmeableitende Halbleiterschicht (310), wobei die wärmeableitende Halbleiterschicht (310) in thermischem Kontakt mit einem ersten Emissionsmodul (110, 120) an einer der optischen Schicht (200) gegenüberliegenden Fläche des ersten Emissionsmoduls (110, 120) steht, wobei das Hybrid-Halbleiterlaser-Bauelement **dadurch gekennzeichnet ist, dass** es ferner enthält:
- zumindest eine erste Zwischenverbindung (251, 252) zum Verbinden des zumindest einen ersten Emissionsmoduls, wobei die erste Zwischenverbindung (251, 252) durch die optische Schicht (200) hindurchgeht.

2. Hybrid-Halbleiterlaser-Bauelement (1) nach Anspruch 1,
wobei das Hybrid-Halbleiterlaser-Bauelement (1) ferner eine zweite Zwischenverbindung (255) zum Verbinden des zumindest einen ersten Emissionsmoduls enthält, wobei die zweite Zwischenverbindung (255) in elektrischem Kontakt mit der wärmeableitenden Halbleiterschicht (310) steht.

3. Hybrid-Halbleiterlaser-Bauelement (1) nach Anspruch 1,
wobei das Hybrid-Halbleiterlaser-Bauelement (1) ferner eine zweite Zwischenverbindung (255) zum Verbinden des zumindest einen ersten Emissionsmoduls aufweist, wobei die zweite Zwischenverbindung (255) durch die optische Schicht (200) hindurchgeht, wobei die zweite Zwischenverbindung (255) vorzugsweise enthält:
- einen ersten Verbindungsabschnitt, der sich in Richtung der wärmeableitenden Schicht erstreckt;
- einen Metallschichtabschnitt, der sich im Wesentlichen parallel zu der wärmeableitenden Halbleiterschicht (310) erstreckt, wobei dieser Abschnitt in elektrischem Kontakt mit dem ersten Verbindungsabschnitt steht,
- einen zweiten Verbindungsabschnitt, der sich in einer Richtung entgegengesetzt zu der wärmeableitenden Schicht erstreckt und durch die optische Schicht (200) hindurchgeht, wobei der zweite Verbindungsabschnitt in elektrischem Kontakt mit dem Metallschichtabschnitt steht.

4. Hybrid-Halbleiterlaser-Bauelement (1) nach einem der Ansprüche 1 bis 3, ferner enthaltend:
- zumindest ein aktives Bauelement (260), wie etwa einen optischen Modulator, wobei das aktive Bauelement (260) in der optischen Schicht (200) aufgenommen ist,
- zumindest eine dritte Zwischenverbindung (256) zum Verbinden des aktiven Bauelements, wobei sich die dritte Zwischenverbindung zwischen dem aktiven Bauelement (260) und einer der wärmeableitenden Halbleiterschicht (310) gegenüberliegenden Seite des Hybrid-Halbleiterlaser-Bauelements (1) erstreckt.

5. Hybrid-Halbleiterlaser-Bauelement (1) nach einem der Ansprüche 1 bis 4, wobei das Bauelement ferner zumindest eine durchgehende vierte Zwischenverbindung (257, 357, 258, 358) aufweist, wobei sich die vierte Zwischenverbindung (257, 357, 258, 358) zwischen einer der wärmeableitenden Halbleiterschicht (310) gegenüberliegenden Seite des Hybrid-Halbleiterlaser-Bauelements (1) und einer der optischen Schicht (200) gegenüberliegenden Seite der wärmeableitenden Halbleiterschicht (310) erstreckt,
und wobei die vierte Zwischenverbindung (257, 357, 258, 358) jeweils auf der Seite des Hybrid-Halbleiterlaser-Bauelements (1) und der Seite der Halbleiterschicht (310) ein jeweiliges Kontaktstück aufweist.

6. Hybrid-Halbleiterlaser-Bauelement (1) nach einem der Ansprüche 1 bis 5, wobei die wärmeableitende Halbleiterschicht (310) eine Siliziumschicht ist.

7. Hybrid-Halbleiterlaser-Bauelement (1) nach einem der Ansprüche 1 bis 6, ferner enthaltend zumindest eine erste Metallschicht (321) in Kontakt mit der wärmeableitenden Halbleiterschicht (310) auf einer dem ersten Emissionsmodul (110, 120) gegenüberliegenden Seite der wärmeableitenden Halbleiterschicht (310).

8. Hybrid-Halbleiterlaser-Bauelement (1) nach einem der Ansprüche 1 bis 7, ferner enthaltend zumindest eine zweite Metallschicht (322, 323, 324) in elektrischem Kontakt mit dem ersten Emissionsmodul auf der der optischen Schicht (200) gegenüberliegenden Seite des ersten Emissionsmoduls (110, 120),
wobei die zweite Metallschicht (322, 323, 324) an dem thermischen Kontakt zwischen der wärmeableitenden Halbleiterschicht (310) und dem ersten Emissionsmodul (110, 120) beteiligt ist.

9. Hybrid-Halbleiterlaser-Bauelement (1) nach Anspruch 8,
wobei die wärmeableitende Halbleiterschicht (310) in elektrischem Kontakt mit der zweiten Metallschicht (322, 323, 324) steht.

10. Hybrid-Halbleiterlaser-Bauelement (1) nach Anspruch 8,
wobei zwischen der zweiten Metallschicht (322, 323, 324) und der wärmeableitenden Halbleiterschicht (310) zumindest eine elektrisch isolierende Schicht (343, 344) vorgesehen ist, die dazu ausgebildet ist, die zweite Metallschicht von der wärmeableitenden Halbleiterschicht (310) elektrisch zu isolieren, wobei die elektrisch isolierende Schicht (343, 344) an dem thermischen Kontakt zwischen der wärmeableitenden Halbleiterschicht (310) und dem ersten Emissionsmodul (110, 120) beteiligt ist.

11. Hybrid-Halbleiterlaser-Bauelement (1) nach einem der Ansprüche 1 bis 10,
wobei das erste Emissionsmodul in einer Einkapselungsschicht (100) eingeschlossen ist, die aus einem isolierenden Material, wie Siliziumnitrid oder Siliziumdioxid, hergestellt ist.

12. Hybrid-Halbleiterlaser-Bauelement (1) nach einem der Ansprüche 1 bis 11, ferner enthaltend zumindest ein zweites Emissionsmodul (120), das einen aktiven Bereich (121) enthält, der aus Halbleitermaterialien mit direkter Bandlücke, wie etwa III-V-Halbleitern, hergestellt und dazu ausgebildet ist, eine elektromagnetische Strahlung mit einer zweiten gegebenen Wellenlänge, die sich von der ersten gegebenen Wellenlänge unterscheidet oder mit ihr identisch ist, zu emittieren,
wobei die optische Schicht (200) ferner zumindest einen zweiten Wellenleiter (220) enthält, der optisch mit dem aktiven Bereich (121) des zweiten Emissionsmoduls (120) gekoppelt ist, wobei der erste Wellenleiter (220) mit dem aktiven Bereich (121) einen optischen Resonanzhohlraum mit der zweiten gegebenen Wellenlänge bildet,
und wobei die wärmeableitende Halbleiterschicht (310) in thermischem Kontakt mit dem zweiten Emissionsmodul (120) an einer der optischen Schicht (200) gegenüberliegenden Fläche des zweiten Emissionsmoduls (120) steht.

13. Verfahren zur Herstellung eines Hybrid-Halbleiterlasers (1), umfassend die folgenden Schritte:
- Bereitstellen einer optischen Schicht (200), die zumindest einen ersten Wellenleiter (210, 220) enthält,
- Bereitstellen zumindest eines ersten Emissionsmoduls (110, 120), das einen aktiven Bereich (111, 112) enthält, der aus Halbleitermaterialien mit direkter Bandlücke, wie etwa III-V-Halbleitern, hergestellt und dazu ausgebildet ist, eine elektromagnetische Strahlung mit einer ersten gegebenen Wellenlänge zu emittieren, wobei der aktive Bereich (111, 112) optisch mit dem ersten Wellenleiter (210, 220) gekoppelt ist und mit dem ersten Wellenleiter (210, 220) einen optischen Resonanzhohlraum mit der ersten gegebenen Wellenlänge bildet,
wobei das Herstellungsverfahren den folgenden Schritt umfasst:
- Bereitstellen einer wärmeableitenden Halbleiterschicht (310), wobei die wärmeableitende Halbleiterschicht (310) in thermischem Kontakt mit dem ersten Emissionsmodul (110, 120) an einer der optischen Schicht (200) gegenüberliegenden Fläche des ersten Emissionsmoduls (110, 120) steht,
wobei das Herstellungsverfahren **dadurch gekennzeichnet ist, dass**
ein Schritt des Bildens zumindest einer ersten Zwischenverbindung (251, 252) zum Verbinden des zumindest einen ersten Emissionsmoduls vorgesehen ist, wobei sich die erste Zwischenverbindung (251, 252) durch die optische Schicht (200) hindurchgehend erstreckt.

14. Herstellungsverfahren nach Anspruch 13,
wobei der Schritt des Bereitstellens einer wärmeableitenden Halbleiterschicht (310) die folgenden Teilschritte umfasst:
- Ausbilden zumindest einer zweiten Metallschicht (322) in thermischem Kontakt mit dem ersten Emissionsmodul (110, 120) an der der optischen Schicht (200) gegenüberliegenden Fläche des ersten Emissionsmoduls (110, 120),
- Bereitstellen der wärmeableitenden Halbleiterschicht (310),
- Ausbilden einer dritten Metallschicht (323) in thermischem Kontakt mit der wärmeableitenden Halbleiterschicht (110, 120),
- molekulares Metallverkleben der zweiten Metallschicht (322) mit der dritten Metallschicht (323) derart, dass die der optischen Schicht gegenüberliegende Fläche des ersten Emissionsmoduls und die wärmeableitende Halbleiterschicht in thermischen Kontakt gebracht werden.

15. Herstellungsverfahren nach Anspruch 13,
wobei bei dem Schritt des Bereitstellens einer wärmeableitenden Halbleiterschicht (310) zwischen dem Teilschritt des Bereitstellens der wärmeableitenden Halbleiterschicht (310) und dem Teilschritt des Ausbildens der dritten Metallschicht (323) der folgende Teilschritt vorgesehen ist:
- Ausbilden zumindest einer elektrisch isolierenden Schicht (343, 344) in thermischem Kontakt mit der wärmeableitenden Halbleiterschicht (110, 120), wobei die elektrisch isolierende Schicht (343, 344) dazu ausgebildet ist, die zweite Metallschicht (322) von der wärmeableitenden Halbleiterschicht (310) elektrisch zu isolieren, wobei die elektrisch isolierende Schicht (343, 344) an dem thermischen Kontakt zwischen der wärmeableitenden Halbleiterschicht (310) und dem ersten Emissionsmodul (110, 120) beteiligt ist.

16. Herstellungsverfahren nach einem der Ansprüche 13 bis 15,
wobei bei dem Schritt des Bereitstellens der optischen Schicht (200) die optische Schicht (200) zumindest einen zweiten Wellenleiter (220) enthält, wobei bei dem Schritt des Bereitstellens des zumindest einen ersten Emissionsmoduls auch ein zweites Emissionsmodul bereitgestellt wird, wobei das zweite Emissionsmodul (120) einen aktiven Bereich (121) enthält, der aus Halbleitermaterialien mit direkter Bandlücke, wie etwa III-V-Halbleitern, besteht und dazu ausgebildet ist, eine elektromagnetische Strahlung mit einer zweiten gegebenen Wellenlänge zu emittieren, die sich von der ersten gegebenen Wellenlänge unterscheidet oder mit ihr identisch ist,
und wobei bei dem Schritt des Bereitstellens der wärmeableitenden Halbleiterschicht (310) die wärmeableitende Halbleiterschicht (310) auch in thermischem Kontakt mit dem zweiten Emissionsmodul (120) an einer der optischen Schicht (200) gegenüberliegenden Fläche des zweiten Emissionsmoduls (110, 120) steht.

## Claims

1. A hybrid semiconductor laser component (1) including:
- at least one first emission module (110, 120) comprising an active zone (111, 121) made of direct-gap semiconductor materials, such as semiconductors III-V, and shaped to emit an electromagnetic radiation at a first given wavelength,
- an optical layer (200) comprising at least one first wave guide (210, 220) optically coupled to the active zone (111, 121) of the at least one first emission module (110, 120), the first wave guide (210, 220) forming with the active zone (111, 121) an optical cavity resonating at the first given wavelength,
the hybrid semiconductor laser component (1) **being characterised in that** it further includes:
- a semiconducting layer (310), called heat-dissipating semiconducting layer, said heat-dissipating semiconducting layer (310) being in thermal contact with the first emission module (110, 120) on a surface of the first emission module (110, 120) which is opposite to the optical layer (200),
- at least one first interconnection (251, 252) to connect the at least one first emission module, said first interconnection (251, 252) passing through the optical layer (200).

2. The hybrid semiconductor laser component (1) according to claim 1, wherein the hybrid semiconductor laser component (1) further comprises a second interconnection (255) to connect the at least one first emission module, the second interconnection (255) being in electrical contact with the heat-dissipating semiconducting layer (310).

3. The hybrid semiconductor laser component (1) according to claim 1, wherein the hybrid semiconductor laser component (1) further comprises a second interconnection (255) to connect the at least one first emission module, said second interconnection (255) passing through the optical layer (200), said second interconnection (255) preferentially comprising:
- a first interconnection portion extending towards the heat-dissipating layer,
- a metal layer portion extending substantially parallel to the heat-dissipating semiconducting layer (310), said portion being in electrical contact with the first interconnection portion,
- a second interconnection portion extending in a direction opposite to the heat-dissipating layer and passing through the optical layer (200), said second interconnection portion being in electrical contact with the metal layer portion.

4. The hybrid semiconductor laser component (1) according to any of claims 1 to 3 further comprising:
- at least one active component (260), such as an optical modulator, said active component (260) being housed in the optical layer (200),
- at least one third interconnection (256) to connect the active component, said third interconnection extending between the active component (260) and a face of the hybrid semiconductor laser component (1) which is opposite to the heat-dissipating semiconducting layer (310).

5. The hybrid semiconductor laser component (1) according to any of claims 1 to 4, wherein the component further comprises at least one fourth interconnection (257, 357, 258, 358), called through fourth interconnection, said fourth interconnection (257, 357, 258, 358) extending between a face of the hybrid semiconductor laser component (1) which is opposite to the heat-dissipating semiconducting layer (310) and a face of the heat-dissipating semiconducting layer (310) which is opposite to the optical layer (200),
and wherein said fourth interconnection (257, 357, 258, 358) has on each of said face of the hybrid semiconductor laser component (1) and of said face of the semiconducting layer (310), a respective contact bump.

6. The hybrid semiconductor laser component (1) according to any of claims 1 to 5, wherein the heat-dissipating semiconducting layer (310) is a silicon layer.

7. The hybrid semiconductor laser component (1) according to any of claims 1 to 6, further including at least one first metal layer (321) in contact with the heat-dissipating semiconducting layer (310) on a face of the heat-dissipating semiconducting layer (310) which is opposite to the first emission module (110, 120).

8. The hybrid semiconductor laser component (1) according to any of claims 1 to 7, further comprising at least one second metal layer (322, 323, 324) in electrical contact with the first emission module on the face of the first emission module (110, 120) which is opposite to the optical layer (200),
and wherein the second metal layer (322, 323, 324) participates in the thermal contact between the heat-dissipating semiconducting layer (310) and the first emission module (110, 120).

9. The hybrid semiconductor laser component (1) according to claim 8, wherein the heat-dissipating semiconducting layer (310) is in electrical contact with the second metal layer (322, 323, 324).

10. The hybrid semiconductor laser component (1) according to claim 8, wherein between the second metal layer (322, 323, 324) and the heat-dissipating semiconducting layer (310), at least one electrically insulating layer (343, 344) shaped to electrically insulate the second metal layer from the heat-dissipating semiconducting layer (310) is provided, the electrically insulating layer (343, 344) participating in the thermal contact between the heat-dissipating semiconducting layer (310) and the first emission module (110, 120).

11. The hybrid semiconductor laser component (1) according to any of claims 1 to 10, wherein the first emission module is included in an encapsulation layer (100) made of an insulator material, such as silicon nitride or silicon dioxide.

12. The hybrid semiconductor laser component (1) according to any of claims 1 to 11, further comprising at least one second emission module (120) comprising an active zone (121) made of direct-gap semiconductor materials, such as semiconductors III-V, and shaped to emit an electromagnetic radiation at a second given wavelength different from or identical to the first given wavelength,
wherein the optical layer (200) further comprises at least one second wave guide (220) optically coupled to the active zone (121) of the second emission module (120), said first wave guide (220) forming with the active zone (121) an optical cavity resonating at the second given wavelength,
and wherein the heat-dissipating semiconducting layer (310) is in thermal contact with the second emission module (120) on a surface of the second emission module (120) which is opposite to the optical layer (200).

13. A method for manufacturing a hybrid semiconductor laser (1), including the following steps of:
- providing an optical layer (200) including at least one first wave guide (210, 220),
- providing at least one first emission module (110, 120) comprising an active zone (111, 112) made of direct-gap semiconductor materials, such as semiconductors III-V, and shaped to emit an electromagnetic radiation at a first given wavelength, the active zone (111, 112) being optically coupled with the first wave guide (210, 220) and forming with the first wave guide (210, 220) an optical cavity resonating at the given wavelength,
the manufacturing method **being characterised in that it** includes the following step of:
- providing a semiconducting layer (310), called heat-dissipating semiconducting layer, said heat-dissipating semiconducting layer (310) being in thermal contact with the first emission module (110, 120) on a surface of the first emission module (110, 120) which is opposite to the optical layer (200),
wherein a step of forming at least one first interconnection (251, 252) to connect the at least first emission module is provided, said first interconnection (251, 252) extending by passing through the optical layer (200).

14. The manufacturing method according to claim 13, wherein the step of providing a heat-dissipating semiconducting layer (310) comprises the following sub-steps of:
- forming at least one second metal layer (322) in thermal contact with the first emission module (110, 120) on the surface of the first emission module (110, 120) which is opposite to the optical layer (200),
- providing the heat-dissipating semiconducting layer (310),
- forming a third metal layer (323) in thermal contact with the heat-dissipating semiconducting layer (110, 120),
- performing a metal molecular bonding of the second metal layer (322) with the third metal layer (323) so as to put the surface of the first emission module which is opposite to the optical layer and the heat-dissipating semiconducting layer into thermal contact.

15. The manufacturing method according to claim 13, wherein during the step of providing a heat-dissipating semiconducting layer (310), between the sub-step of providing the heat-dissipating semiconducting layer (310) and the sub-step of forming the third metal layer (323), the following sub-step is provided
- forming at least one electrically insulating layer (343, 344) in thermal contact with the heat-dissipating semiconducting layer (110, 120),
the electrically insulating layer (343, 344) being shaped to electrically insulate the second metal layer (322) of the heat-dissipating semiconducting layer (310), the electrically insulating layer (343, 344) participating in the thermal contact between the heat-dissipating semiconducting layer (310) and the first emission module (110, 120).

16. The manufacturing method according to any of claims 13 to 15, wherein during the step of providing the optical layer (200), the optical layer includes at least one second wave guide (220),
wherein during the step of providing the at least one first emission module, a second emission module is also provided, the second emission module (120) comprising an active zone (121) made of direct-gap semiconductor materials, such as semiconductors III-V, and shaped to emit an electromagnetic radiation at a second given wavelength different from or identical to the first given wavelength,
and wherein during the step of providing the heat-dissipating semiconducting layer (310), said heat-dissipating semiconducting layer (310) is also in thermal contact with the second emission module (120) on a surface of the second emission module (110, 120) which is opposite to the optical layer (200).
